(19) **Europäisches Patentamt / European Patent Office / Office européen des brevets**

(11) **EP 4 786 163 A1**

(12) **EUROPEAN PATENT APPLICATION**
published in accordance with Art. 153(4) EPC

(43) Date of publication:
05.08.2026 Bulletin 2026/32

(21) Application number: 24872588.9

(22) Date of filing: 30.09.2024

(51) International Patent Classification (IPC):
$B32B\ 9/00^{(2006.01)}$   $B32B\ 27/00^{(2006.01)}$
$B32B\ 27/32^{(2006.01)}$   $B65D\ 65/40^{(2006.01)}$
$C23C\ 14/08^{(2006.01)}$

(52) Cooperative Patent Classification (CPC):
B32B 9/00; B32B 27/00; B32B 27/32; B65D 65/40;
C23C 14/08

(86) International application number:
PCT/JP2024/034877

(87) International publication number:
WO 2025/070809 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 29.09.2023 JP 2023169143
01.08.2024 JP 2024126155

(71) Applicant: Dai Nippon Printing Co., Ltd.
Tokyo 162-8001 (JP)

(72) Inventors:
• MORIMOTO Taro
Tokyo 162-8001 (JP)
• SHIBATA Takafumi
Tokyo 162-8001 (JP)

• MIZOSHIRI Makoto
Tokyo 162-8001 (JP)
• KOICHI MATSUMOTO Chisayo
Tokyo 162-8001 (JP)
• SUZUKI Tsuyoshi
Tokyo 162-8001 (JP)
• HACHIYA Yuki
Tokyo 162-8001 (JP)
• KONISHI Kenta
Tokyo 162-8001 (JP)
• TAMADA Shuhei
Tokyo 162-8001 (JP)

(74) Representative: Müller-Boré & Partner
Patentanwälte PartG mbB
Friedenheimer Brücke 21
80639 München (DE)

(54) **BARRIER FILM AND LAMINATE USING SAME**

(57)     Provided is a barrier film that includes a vapor deposition film and a covering layer formed on an OPP film substrate, and that is capable of suppressing deterioration of barrier properties after heat sterilization treatment; and a laminate using the barrier film. This barrier film is obtained by sequentially laminating a biaxially stretched polypropylene substrate, a base layer, and an aluminum oxide vapor deposition film. A peak top ratio P based on X-ray absorption fine structure analysis of the aluminum oxide vapor deposition film is 0.70 or more and less than 1.05. P = (intensity peak top at around 1,572 eV) / (intensity peak top at around 1,566 eV)

FIG. 1

**Description**

TECHNICAL FIELD

The present invention relates to a barrier film and a multilayer member using such a barrier film.

BACKGROUND ART

Conventionally, a multilayer film which includes a film formed on a base material such as a long film or sheet made of plastic or the like has been used for various applications. For example, a barrier multilayer film has been developed in which a barrier layer formed with a thin film of an aluminum oxide or the like is provided on a plastic film to provide a barrier function against oxygen and water vapor.

For example, Patent Document 1 discloses that, as a method for manufacturing a barrier film including an aluminum oxide thin film, a plasma activation vapor deposition method (so-called plasma assisted method during vapor deposition) for generating high-density plasma in a space between an aluminum evaporation source and a polymer film is used, and thus a gas barrier film having excellent transparency and gas barrier properties is obtained.

Patent Document 2 discloses an aluminum oxide vapor-deposited film in which a vapor-deposited film of a low aluminum oxide is provided on a transparent plastic film, the vapor-deposited film of the aluminum suboxide is subjected to plasma treatment containing oxygen gas to form a vapor-deposited film of a high aluminum oxide and heat treatment is further performed at high humidity to provide a vapor-deposited film of an aluminum hydroxide.

On the other hand, in recent years, in terms of environmental consideration, a mono-material packaging material has been considered to enhance the recyclability of a packaging material. For example, a multilayer member in which instead of a polyester film (PET film) which has been widely used, a polyolefin film such as a biaxially stretched polypropylene film (OPP film) is applied to a base material, and as a sealant layer stacked thereon, a polyolefin film such as a non-stretched polypropylene film (CPP film) is used has been considered as a mono-material packaging material.

For example, Patent Document 3 listed below discloses a gas barrier multilayer member which includes a base material layer including a polyolefin resin, a barrier layer and an overcoat layer including a polyvinyl alcohol resin, and in which the surface hardness of the overcoat layer is equal to or less than 1.5 GPa when measured by a nanoindentation method. As described above, a multilayer member which includes: a barrier film where a biaxially stretched polypropylene base material, an inorganic oxide vapor-deposited film and a covering layer having barrier properties are stacked in this order; and a sealant layer is known as a polyolefin mono-material packaging material.

Citation List

Patent Documents

Patent Document 1: Japanese Unexamined Patent Application, Publication No. 2017-177343
Patent Document 2: Japanese Unexamined Patent Application, Publication No. H11-170427
Patent Document 3: International Publication No. WO2022/085586

DISCLOSURE OF THE INVENTION

Problems to be Solved by the Invention

When a multilayer member formed of a polyolefin mono-material packaging material is subjected to heat sterilization treatment such as boiling treatment or retort treatment, an OPP film is inferior in heat resistance and strength to a PET film. Hence, the barrier properties of the OPP film after the heat sterilization treatment are significantly lowered compared to the PET film.

In this regard, in a conventional barrier film, a vapor-deposited film which is suitable for the OPP film as a vapor deposition base material and a covering layer which is provided as necessary have not been sufficiently considered, and in particular, in a multilayer member, a vapor-deposited film and a covering layer which can withstand heat sterilization treatment need to be further considered.

Although in Patent Document 3, the composite elastic modulus and hardness of the covering layer are specified, there is a problem in the "processability" of the barrier film. Hence, in Patent Document 3, the composite elastic modulus and hardness of the covering layer "before the heat sterilization treatment" are only specified, and the heat sterilization treatment and barrier properties after the heat sterilization treatment are not described at all.

It has been found from studies of the present inventors and others that the composite elastic modulus and hardness of a covering layer vary depending on whether the covering layer has been stacked and whether the covering layer has been subjected to heat sterilization treatment. Hence, even when as in Patent Document 3, the composite elastic modulus and hardness of the covering layer "before the heat sterilization treatment" are specified, it is impossible to predict the suppression of a decrease in barrier properties when the multilayer member is subjected to the heat sterilization treatment.

Means for Solving the Problems

In order to solve the problems described above, the present inventors have conducted thorough studies to find a barrier film which forms a multilayer member serving as a polyolefin mono-material packaging material, that is, a vapor-deposited film formed on an OPP film base material and a covering layer provided as necessary which are suitable for heat sterilization treatment applications when being stacked as a multilayer member, and consequently have completed the present invention. Specifically, the present invention provides the following.

(1) A barrier film comprising a polypropylene base material, an underlayer and an aluminum oxide vapor-deposited film that are stacked in this order,
wherein when an X-ray absorption fine structure analysis is performed from a side of a surface of the barrier film opposite to a side of the polypropylene base material, in the aluminum oxide vapor-deposited film, a peak top ratio P defined by an equation below is equal to or greater than 0.70 and less than 1.05. P = (intensity peak top at around 1572 eV) / (intensity peak top at around 1566 eV)
(2) The barrier film described in (1), where a covering layer having barrier properties is stacked on the aluminum oxide vapor-deposited film.
(3) The barrier film described in (2), where in the covering layer, a ratio of silicon atoms to carbon atoms (Si/C) measured by X-ray photoelectron spectroscopy (XPS) is equal to or greater than 1.30 and equal to or less than 1.65.
(4) The barrier film described in (1), where the underlayer is an anchor coat layer formed on the polypropylene base material.
(5) The barrier film described in (1), where the underlayer is a surface resin layer formed on the polypropylene base material, the surface resin layer including a polyamide resin.
(6) The barrier film described in (4), where the polypropylene base material includes at least a first layer and a second layer as both surface layers, the first layer is formed on a side of the underlayer,

the first layer contains a copolymer of propylene and another monomer,
the underlayer is the anchor coat layer and
the first layer of the polypropylene base material, the anchor coat layer, the aluminum oxide vapor-deposited film and a covering layer having barrier properties are stacked in this order.

(7) The barrier film described in (4), where the polypropylene base material includes at least a first layer and a second layer as both surface layers, the first layer is formed on a side of the underlayer,

the first layer contains a modified polypropylene,
the underlayer is the surface resin layer including the polyamide resin and
the first layer of the polypropylene base material, the surface resin layer including the polyamide resin, the aluminum oxide vapor-deposited film and a covering layer having barrier properties are stacked in this order.

(8) The barrier film described in (1), where the polypropylene base material includes at least a first layer and a second layer as both surface layers, the second layer is formed on a surface on a side opposite to a side of the underlayer,

the second layer contains a copolymer of propylene and another monomer and
the first layer of the polypropylene base material, the underlayer, the aluminum oxide vapor-deposited film and a covering layer having barrier properties are stacked in this order.

(9) A multilayer member that is used for a packaging bag containing retort pouch food or boiled food and has been subjected to heat sterilization treatment, the multilayer member including the barrier film described in any one of (1) to (8) and a sealant layer,
where in a covering layer of the multilayer member, a composite elastic modulus measured from a cross section of the covering layer by a nanoindentation method is equal to or greater than 5.0 GPa and equal to or less than 8.5 GPa, and an indentation hardness measured from the cross section of the covering layer by the nanoindentation method is equal to or greater than 0.9 GPa and equal to or less than 1.7 GPa.

(10) A packaging product including the multilayer member described in (9).

Effects of the Invention

Although a barrier film in the present invention includes a vapor-deposited film formed on an OPP film base material and a covering layer provided as necessary, the barrier film in the present invention can suppress a decrease in barrier properties after heat sterilization treatment.

BRIEF DESCRIPTION OF THE DRAWINGS

FIG. 1 is a cross-sectional view showing an example of a barrier film according to the present embodiment;
FIG. 2 is a diagram showing an example of a film formation device in the present embodiment of the present invention;
FIG. 3 is a cross-sectional view showing an example of a plasma pretreatment mechanism in the film formation device;
FIG. 4 is a plan view showing an example of the electrode unit and the magnetic field formation unit of the plasma pretreatment mechanism in the film formation device;
FIG. 5 is a cross-sectional view showing an example of the electrode unit and the magnetic field formation unit of the plasma pretreatment mechanism in the film formation device; FIG. 6 is a cross-sectional view showing an example of a film formation mechanism in the film formation device;
FIG. 7 is a cross-sectional view showing an example of a multilayer member which uses the barrier film in the present invention;
FIG. 8 is a cross-sectional view showing another example of the multilayer member which uses the barrier film in the present invention;
FIG. 9 is a diagram showing an XAFS spectrum of a barrier film in Example 1;
FIG. 10 is a diagram showing the analysis results of the XAFS spectrum of the barrier film in Example 1;
FIG. 11 is a diagram showing the analysis results of an XAFS spectrum of a barrier film in Example 2;
FIG. 12 is a diagram showing the analysis results of an XAFS spectrum of a barrier film in Comparative Example 4; and
FIG. 13 is a diagram showing the analysis results of an XAFS spectrum of a barrier film in Comparative Example 5.

PREFERRED MODE FOR CARRYING OUT THE INVENTION

Although a specific embodiment of the present invention will be described in detail below, the present invention is not limited to the following embodiment at all, and changes can be made as necessary within the scope of the object of the present invention. In the present specification, "X to Y" (X and Y are arbitrary numerical values) means "equal to or greater than X and equal to or less than Y".

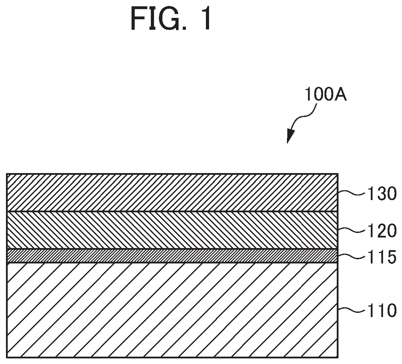

FIG. 1 is a cross-sectional view showing an example of a barrier film according to the present embodiment. The barrier film manufactured using a film formation device according to the present embodiment includes, for example, as the barrier film 100A shown in FIG. 1, a base material 100 which corresponds to a biaxial polypropylene base material in the present invention, an underlayer 115, a vapor-deposited film 120 and a covering layer 130 which is provided as necessary. In the example shown in FIG. 1, the underlayer 115 is located on one surface of the base material 100. In the example shown in FIG. 1, in the barrier film 100A, the base material 100, the underlayer 115, the vapor-deposited film 120 and the covering layer 130 are stacked in this order, and the covering layer 130 is located in the surface of the barrier film. The vapor-deposited film 120 and the covering layer 130 form a barrier layer.

In the present specification, the "stacked in this order" means that as long as a polypropylene base material, an underlayer, an aluminum oxide vapor-deposited film and a covering layer having barrier properties are stacked to be arranged in this order, for example, a layer such as an anchor coat layer which will be described later may be further stacked between these layers.

The layers of the barrier film 100A will be described below.

[Polypropylene base material]

The polypropylene base material 100 is a polypropylene base material which has been subjected to biaxial stretching treatment. In the following description, when the "polypropylene base material" is simply described, the "polypropylene base material" means a polypropylene base material which has been subjected to biaxial stretching treatment except in a case where stretching treatment is described.

The polypropylene base material is formed of at least polypropylene. The polypropylene may be any of a propylene homopolymer, a propylene random copolymer and a propylene block copolymer, or may be a mixture of two or more selected from these.

The propylene homopolymer is a polymer made of only propylene. The propylene random copolymer is a random copolymer of propylene and an $\alpha$-olefin or the like other than propylene. The propylene block copolymer is a copolymer which includes a polymer block formed of propylene and a polymer block formed of at least an $\alpha$-olefin or the like other than propylene. The latter polymer block may be a polymer block formed of propylene and an $\alpha$-olefin other than propylene.

As the $\alpha$-olefin, for example, an $\alpha$-olefin having 2 to 20 carbon atoms is mentioned, and specific examples thereof include ethylene, 1-butene, 1-pentene, 1-hexene, 1-octene, 1-decene, 1-dodecene, 1-tetradecene, 1-hexadecene, 1-octadecene, 1-eicosene, 3-methyl-1-butene, 4-methyl-1-pentene and 6-methyl-1-heptene.

Among the polypropylenes, in terms of transparency, the random copolymer is preferably used. When emphasis is placed on the rigidity and heat resistance of a multilayer member, the homopolymer is preferably used. When emphasis is placed on the impact resistance of the multilayer member, the block copolymer is preferably used.

In an embodiment, in terms of film formation properties and processability, the melt flow rate (MFR) of the polypropylene may be equal to or greater than 0.1 g / 10 min and equal to or less than 50 g / 10 min, or may be equal to or greater than 0.3 g / 10 min and equal to or less than 30 g / 10 min. The MFR of the polypropylene is measured in accordance with ASTM D1238 at a temperature of 230°C and a load of 2.16 kg.

As the polypropylene, a biomass-derived polypropylene or a mechanically recycled or chemically recycled polypropylene may be used.

The content of the polypropylene in the polypropylene base material is preferably equal to or greater than 70% by mass, more preferably equal to or greater than 80% by mass, further preferably equal to or greater than 90% by mass and still further preferably equal to or greater than 95% by mass.

The polypropylene base material may contain a resin material other than the polypropylene. Examples of the resin material include polyolefin such as polyethylene, a (meth)acrylic resin, a vinyl resin, a cellulose resin, polyamide, polyester and an ionomer resin.

The polypropylene base material may contain an additive. Examples of the additive include a crosslinking agent, an antioxidant, an antiblocking agent, a slip agent, an ultraviolet absorber, a light stabilizer, a filler, a reinforcing agent, a lubricant, an antistatic agent, a pigment and a modifying resin.

The polypropylene base material is a base material which has been subjected to the biaxial stretching treatment. In this way, it is possible to enhance, for example, the heat resistance, the impact resistance, the water resistance and the dimensional stability of a barrier base material. The multilayer member including the barrier base material as described above is suitable as a packaging material which is subjected to boiling treatment or retort treatment.

A stretching ratio when stretching is performed in a longitudinal direction (the direction of flow of the base material, an MD direction) is preferably equal to or greater than two times and equal to or less than 15 times, and more preferably equal to or greater than 5 times and equal to or less than 13 times. A stretching ratio when stretching is performed in a lateral direction (direction perpendicular to the MD direction, a TD direction) is preferably equal to or greater than two times and equal to or less than 15 times, and more preferably equal to or greater than 5 times and equal to or less than 13 times. The stretching ratio is set equal to or greater than two times, and thus it is possible to more enhance the strength and the heat resistance of the polypropylene base material, and when the polypropylene base material is used as an outermost layer, the printability of the polypropylene base material can be enhanced. In terms of the breaking limit of the polypropylene base material, the stretching ratio is preferably equal to or less than 15 times.

The thickness of the polypropylene base material is preferably equal to or greater than 10 $\mu$m and equal to or less than 100 $\mu$m, more preferably equal to or greater than 10 $\mu$m and equal to or less than 50 $\mu$m and further preferably equal to or greater than 15 $\mu$m and equal to or less than 25 $\mu$m. When the thickness is equal to or greater than a lower limit value, for example, the strength and the heat resistance of the barrier base material can be more enhanced. When the thickness is equal to or less than an upper limit value, for example, the processability of the barrier base material can be more enhanced.

The polypropylene base material may be a coextruded stretched film. A multilayer film is formed by utilizing, for example, a conventionally known T-die method or inflation method, then the multilayer film is stretched and thus it is possible to produce the coextruded stretched film. When formed by the inflation method, the multilayer film may be stretched simultaneously.

The polypropylene base material may be subjected to surface treatment. In this way, for example, it is possible to enhance adhesion between the polypropylene base material and other layers. Examples of the surface treatment method include: physical treatments such as corona discharge treatment, ozone treatment, low-temperature plasma treatment using one or more gases selected from oxygen gas, argon gas, nitrogen gas and the like and glow discharge treatment; and chemical treatments such as oxidation treatment using chemical agents. In addition, an adhesion-promoting layer may be provided on the surface of the polypropylene base material.

When the polypropylene base material is used as the outermost layer of the multilayer member, a printing layer may be provided on a second layer. An image formed on the printing layer is not particularly limited, and examples thereof include a character, a pattern, a symbol and a combination thereof. The formation of the printing layer can be performed using a biomass-derived ink. In this way, it is possible to more reduce an environmental load.

Examples of a method for forming the printing layer include conventionally known printing methods such as a gravure printing method, an offset printing method and a flexographic printing method. Among them, in terms of reducing an environmental load, the flexographic printing method is preferable.

The polypropylene base material is preferably transparent. Specifically, a total light transmittance measured according to JIS K 7361-1: 1997 is preferably high. Specifically, the total light transmittance is preferably equal to or greater than 70%, more preferably equal to or greater than 80% and particularly preferably equal to or greater than 90%.

The base material 100 of a winding member is preferably humidity-conditioned in a step of forming the underlayer or in a humidity-conditioning step after the formation of the underlayer. In this way, it is possible to enhance barrier properties. It is also possible to prevent breakage of the base material caused by sticking during unwinding in a vapor deposition step which will be described later. One example of conditions of humidity conditioning is storage at a temperature of 22 to 30°C and a relative humidity of 40 to 65% RH for 1 to 7 days. It is also effective to rewind the winding member before storing it for humidity conditioning. In this case, it is preferable to perform a rewinding step under the conditions of humidity conditioning described above.

The polypropylene base material may be a multilayer film which includes at least a first layer and a second layer. The first layer is a layer on one side (side on which the barrier layer such as the vapor-deposited film is formed) of the polypropylene base material, and the second layer is a layer on the other side of the polypropylene base material.

Each of the first layer and the second layer may be made of a propylene random copolymer which is a random copolymer of propylene and an $\alpha$-olefin or the like other than propylene. Each of the first layer and the second layer is made of a random copolymer, and thus it is possible to enhance adhesion between the layer and other layers in contact therewith. Examples of the $\alpha$-olefin include ethylene, 1-butene, 1-hexene and the like.

The first layer may be made of a modified polypropylene. When the underlayer which will be described later is made of a polyamide resin, adhesion to the polyamide resin is enhanced.

The polypropylene base material may include a third layer as an intermediate layer between the first layer and the second layer. The intermediate layer preferably includes a homopolymer of the polypropylene. The intermediate layer may have a single layer structure or a multilayer structure.

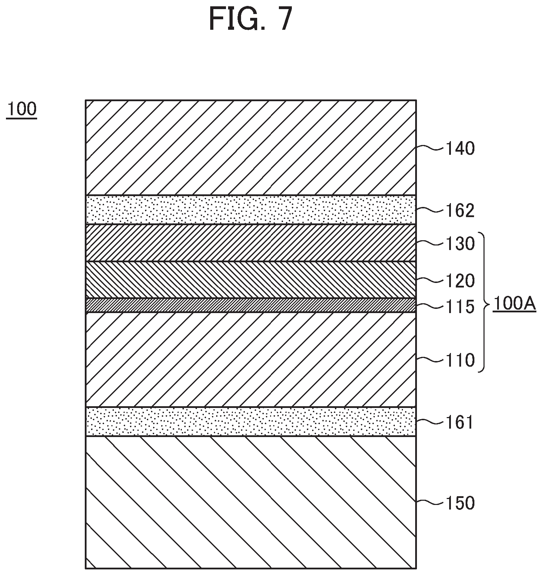

A specific example of a three-layer configuration is a structure of a propylene random copolymer, a propylene homopolymer and a propylene random copolymer in the order of the first layer, the third layer and the second layer when viewed from a side on which the vapor-deposited film is formed. In this case, the first layer is made of a propylene random copolymer, and thus when the underlayer which will be described later is an anchor coat layer, adhesion to the anchor coat layer is enhanced. The second layer is made of a propylene random copolymer, and thus for example, when a multilayer member which is shown in FIG. 7 and will be described later is formed, adhesion to a first adhesive layer 161 for stacking a sealant layer 150 is enhanced.

Another specific example of the three-layer configuration is a structure of a modified polypropylene, a propylene homopolymer and a propylene random copolymer in the order of the first layer, the third layer and the second layer when viewed from the side on which the vapor-deposited film is formed. In this case, the first layer is made of the modified polypropylene, and thus when the underlayer which will be described later is made of a polyamide resin, adhesion to the polyamide resin is enhanced. The third layer is made of a propylene random copolymer, and thus for example, when the multilayer member which is shown in FIG. 7 and will be described later is formed, adhesion to the first adhesive layer 161 for stacking the sealant layer 150 is enhanced.

[Underlayer]

On the surface of the base material 100 where the vapor-deposited film 120 is formed, the underlayer 150 is formed. When the underlayer is a surface resin layer formed of a high-melting point resin material which will be described later, vapor deposition resistance is enhanced, and thus the migration of a vapor deposition material is facilitated, with the result that a vapor-deposited film formed with a dense, continuous layer with few gaps and excellent flexibility is obtained. Since the underlayer is made of the high-melting point resin material, resistance to heat sterilization treatment is enhanced. When the underlayer is the anchor coat layer formed by coating which will be described later, the surface of the base material can be made smoother, the migration of the vapor deposition material is facilitated, and the adhesion strength between the polypropylene base material and the vapor-deposited film is enhanced, with the result that the vapor-deposited film formed with a dense, continuous layer with few gaps and excellent flexibility is obtained. In this way, it is possible to obtain high gas barrier properties, and to suppress the breakage of the vapor-deposited film and the covering layer caused by deformation or bending of the film and a decrease in gas barrier properties. Then, it is possible to obtain the barrier film which can withstand heat sterilization treatment and has excellent heat resistance.

(Surface resin layer)

The underlayer is preferably the surface resin layer. On the polypropylene base material, the surface resin layer is provided which preferably includes the resin material (hereinafter also referred to as the high-melting point resin material) having a melting point of 180°C or more, and thus the dense vapor-deposited film with few gaps can be formed on the surface resin layer, with the result that it is possible to enhance gas barrier properties.

The melting point of the high-melting point resin material is more preferably equal to or greater than 100°C, further preferably equal to or greater than 180°C and particularly preferably equal to or greater than 200°C. The melting point of the high-melting point resin material is set equal to or greater than 100°C, and thus when a copolymer of propylene and another monomer or a modified polypropylene is provided as the second layer, the second layer can be protected from the vapor deposition material. The melting point of the high-melting point resin material is set equal to or greater than 180°C, and thus the denseness of the vapor-deposited film can be enhanced, with the result that it is possible to more enhance gas barrier properties. It is also possible to more enhance resistance to heat sterilization treatment on the multilayer member. In terms of film formation properties, the melting point of the high-melting point resin material is preferably equal to or less than 265°C, more preferably equal to or less than 260°C and further preferably equal to or less than 250°C. In the present specification, the melting point can be measured in accordance with JIS K 7121: 2012 (Method for measuring transition temperature of plastics). Specifically, the melting point can be determined by measuring a DSC curve at a temperature rise rate of 10°C/min using a differential scanning calorimetry (DSC) device.

A difference between the melting point of the high-melting point resin material included in the surface resin layer and the melting point of the polypropylene included in a biaxially stretched polypropylene base material is preferably 20 to 100°C, and is more preferably 20 to 70°C. The difference between the melting points is equal to or greater than 20°C, and thus the denseness of the vapor-deposited film can be more enhanced, with the result that it is possible to more enhance gas barrier properties. It is also possible to more enhance resistance to heat sterilization treatment on the multilayer member. The difference between the melting points is equal to or less than 100°C, and thus it is possible to more enhance film formation properties.

The high-melting point resin material preferably includes a polar group. In the present invention, the polar group refers to a group including one or more heteroatoms, and examples thereof include an ester group, an epoxy group, a hydroxyl group, an amino group, an amide group, a carboxyl group, a carbonyl group, a carboxylic anhydride group, a sulfone group, a thiol group, a halogen group and the like. Among them, in terms of the laminate strength of a packaging container, a hydroxyl group, an ester group, an amino group, an amide group, a carboxyl group and a carbonyl group are preferable, and a hydroxyl group is more preferable.

When the high-melting point resin material has a melting point of 180°C or more, the high-melting point resin material can be used without particular limitation. Examples of the high-melting point resin material include a vinyl resin, polyamide, polyimide, polyester, a (meth)acrylic resin, a cellulose resin, a polyolefin resin, an ionomer resin and the like.

In the present invention, the high-melting point resin material particularly preferably has a melting point of 180°C or more and is the resin material including a polar group, is preferably an ethylene-vinyl alcohol copolymer, polyvinyl alcohol, polyester or polyamide and is more preferably polyamide such as nylon 6 (in the following description, "nylon" is a registered trademark), nylon 6,6, aromatic-containing nylon or amorphous nylon. The resin material as described above is used, and thus it is possible to effectively enhance the gas barrier properties of the vapor-deposited film formed on the surface resin layer.

As the high-melting point resin material, polyamide is used, and thus it is possible to suppress a decrease in gas barrier properties even when the barrier multilayer member is heated. As the high-melting point resin material, polyamide containing a benzene ring (aromatic) is preferable in terms of mechanical strength and gas barrier properties. The polyamide containing a benzene ring can be combined and coextruded with other materials. As the polyamide containing a benzene ring, Nylon MXD6 made by Mitsubishi Gas Chemical Company, Inc. or the like is mentioned.

The polyamide containing a benzene ring is a polyamide which contains a benzene ring in either or both of a structural unit derived from a diamine and a structural unit derived from a dicarboxylic acid. A copolymer of one or more diamines and one or more dicarboxylic acids may be used. A mixture of two or more copolymers may be used. Examples of the copolymer include a copolymer of a diamine containing a benzene ring and an aliphatic dicarboxylic acid, a copolymer of an aliphatic diamine and a dicarboxylic acid containing a benzene ring, a copolymer of a diamine containing a benzene ring, a dicarboxylic acid containing a benzene ring and an aliphatic dicarboxylic acid and a copolymer of an aliphatic diamine, a diamine containing a benzene ring and a dicarboxylic acid containing a benzene ring.

The surface resin layer may include a polyamide which does not contain a benzene ring. Polyester, an acrylic resin, an ionomer resin or the like may be added as long as it does not affect processability and physical properties.

The diamine containing a benzene ring is metaxylenediamine, paraxylenediamine, meta phenylenediamine, paraphenylenediamine or the like. One or more of them are used.

The dicarboxylic acid containing a benzene ring is an aromatic dicarboxylic acid such as terephthalic acid (TPA) or isophthalic acid (IPA) or a naphthalenedicarboxylic acid such as 1,2-naphthalenedicarboxylic acid, 1,3-naphthalenedicarboxylic acid, 1,4-naphthalenedicarboxylic acid, 1,5-naphthalenedicarboxylic acid, 1,6-naphthalenedicarboxylic acid, 1,7-naphthalenedicarboxylic acid, 1,8-naphthalenedicarboxylic acid, 2,3-naphthalenedicarboxylic acid, 2,6-naphthalenedicarboxylic acid or 2,7-naphthalenedicarboxylic acid. One or more of them are used.

The aliphatic diamine is a linear aliphatic diamine such as 1,4-butanediamine, 1,5-pentanediamine, 1,6-hexanediamine (hexamethylenediamine), 1,7-heptanediamine, 1,8-octanediamine, 1,9-nonanediamine (NDA), 1,10-decanediamine (DDA), 1,11-undecanediamine or 1,12-dodecanediamine, a branched aliphatic diamine such as 2-methyl-1,8-octanediamine (MODA), 4-methyl-1,8-octanediamine, 5-methyl-1,9-nonanediamine, 2,2,4-/2,4,4-trimethyl-1,6-hexanediamine, 2-methyl-1,5-pentanediamine, 2-methyl-1,6-hexanediamine or 2-methyl-1,7-heptanediamine, an alicyclic diamine such as isophoronediamine, norbornanedimethylamine or tricyclodecanedimethylamine or the like. One or more of them are used.

The aliphatic dicarboxylic acid is an aliphatic dicarboxylic acid having 2 to 20 carbon atoms. In consideration of polymerizability, processability and the like, adipic acid is most preferable, and examples of other dicarboxylic acids include oxalic acid, malonic acid, succinic acid, glutaric acid, pimelic acid, suberic acid, azelaic acid, sebacic acid, undecanedioic acid, dodecadioic acid, hexadecadioic acid, eicosanedioic acid, eicosadienedioic acid, 2,2,4-trimethyladipic acid and the like. One or more of them are used.

The polyamide which does not contain a benzene ring is a polyamide 6, a polyamide 7, a polyamide 10, a polyamide 11, a polyamide 12, a polyamide 410, a polyamide 56, a polyamide 66, a polyamide 69, a polyamide 610, a polyamide 611, a polyamide 612, a polyamide 1010 or the like. The surface resin layer may include one or more of them.

The surface resin layer preferably includes 20% or more by mass of the polyamide containing a benzene ring in the surface resin layer, more preferably includes 30% or more by mass thereof and further preferably includes 40% or more by mass thereof. The surface resin layer includes 20% or more by mass of the polyamide containing a benzene ring, thereby it is possible to suppress wet heat swelling and thus adhesion to the vapor-deposited film is enhanced, with the result that it is possible to reduce a decrease in the barrier properties of the vapor-deposited film during heat sterilization caused by boiling treatment or retort treatment. When the surface resin layer includes less than 20% by mass thereof, adhesion to the vapor-deposited film may be poor, and the barrier properties may be lowered during heat sterilization.

The surface resin layer preferably includes 20% or more by mass of crystalline polyamide, more preferably includes 30% or more by mass thereof and further preferably includes 40% or more by mass thereof. The surface resin layer includes 20% or more by mass of crystalline polyamide, and thus it is possible to enhance gas barrier properties and suppress wet heat swelling. Examples of the crystalline polyamide include a copolymer of metaxylenediamine and adipic acid, a copolymer of hexamethylenediamine and terephthalic acid, polyamide 6 and the like.

The surface resin layer preferably includes 90% or less by mass of crystalline polyamide, more preferably includes 80% or less by mass thereof and further preferably includes 70% or less by mass thereof. In this way, it is possible to mix amorphous polyamide which will be described later.

The surface resin layer preferably includes 10% or more by mass of amorphous polyamide, more preferably includes 20% or more by mass thereof and further preferably includes 30% or more by mass thereof. The surface resin layer includes 10% or more by mass of amorphous polyamide, and thus extrusion and stretchability are enhanced, with the result that it is easy to manufacture a base material film 10. Examples of the amorphous polyamide include a copolymer of hexamethylenediamine and isophthalic acid, a copolymer of metaxylenediamine and isophthalic acid, a copolymer of hexamethylenediamine and dicarboxylic acid in which the molar ratio of isophthalic acid to terephthalic acid is 2/1, a copolymer of metaxylenediamine and dicarboxylic acid in which the molar ratio of adipic acid to isophthalic acid is 1/1 and the like.

The surface resin layer preferably includes 80% or less by mass of amorphous polyamide, more preferably includes 70% or less by mass thereof and further preferably includes 60% or less by mass thereof. In this way, it is possible to mix crystalline polyamide.

The thickness of the surface resin layer is preferably equal to or greater than 0.1 $\mu$m and equal to or less than 5 $\mu$m, and more preferably equal to or greater than 0.2 $\mu$m and equal to or less than 4 $\mu$m. The thickness of the surface resin layer is set equal to or greater than 0.1 $\mu$m, and thus the denseness of the vapor-deposited film can be more enhanced, with the result that it is possible to more enhance gas barrier properties. The thickness of the surface resin layer is set equal to or less than 5 $\mu$m, and thus it is possible to more enhance film formation properties and processability.

The surface resin layer can be formed by a melt extrusion method. The polypropylene base material in the present invention may be formed by extrusion onto a biaxially stretched polypropylene film, or may be formed by coextrusion of a multilayer with the polypropylene and then stretching.

The underlayer may be the anchor coat layer. The anchor coat layer can be formed by coating using a resin material including a polar group. As the resin material including a polar group, an ethylene-vinyl alcohol copolymer (EVOH), polyvinyl alcohol (PVA), polyester, polyethyleneimine, a hydroxyl group-containing (meth)acrylic resin, nylon 6, nylon 6,6, aromatic-containing nylon, amorphous nylon, polyurethane or the like is preferable, and a hydroxyl group-containing (meth)acrylic resin, an ethylene-vinyl alcohol copolymer or polyvinyl alcohol is more preferable. As the resin material including a polar group, a (meth)acrylic resin containing a urethane group and a hydroxyl group is particularly preferable in terms of smoothness and gas barrier properties after heat sterilization treatment derived from high cohesive energy.

In terms of adhesion to the vapor-deposited film, a silane coupling agent is preferably added to the anchor coat layer. As the silane coupling agent, silane coupling agents which will be described later can be applied.

In the present invention, the anchor coat layer can be formed using a water-based emulsion or a solvent-based emulsion. Specific examples of the water-based emulsion include a polyamide emulsion, a polyethylene emulsion, a polyurethane emulsion and the like, and specific examples of the solvent-based emulsion include a polyester emulsion and the like.

As the polyurethane emulsion, for example, a mixed liquid of a polyurethane emulsion and an emulsion of an oxazoline group-containing polymer is preferably used. Furthermore, the polyurethane emulsion may include a silane coupling agent.

The thickness of the anchor coat layer is preferably equal to or greater than 0.02 $\mu$m and equal to or less than 10 $\mu$m, more preferably equal to or greater than 0.05 $\mu$m and equal to or less than 8 $\mu$m, further preferably equal to or greater than 0.1 $\mu$m and equal to or less than 5 $\mu$m and still further preferably equal to or greater than 0.2 $\mu$m and equal to or less than 3 $\mu$m. The thickness of the anchor coat layer is set equal to or greater than 0.02 $\mu$m, and thus smoothness can be more enhanced, and gas barrier properties after the vapor deposition can be more enhanced. The thickness of the anchor coat layer is set equal to or less than 10 $\mu$m, and thus processability and productivity can be more enhanced.

The anchor coat layer may be formed by coating (application, coating process) on the biaxially stretched polypropylene base material, and may be formed by coating on a polypropylene film and then biaxially stretching.

[Vapor-deposited film]

The vapor-deposited film 120 will then be described. The vapor-deposited film includes an aluminum oxide of an inorganic oxide. In the vapor-deposited film, at least a part of aluminum exists in the form of $Al_2O_3$. The vapor-deposited film may further include metal oxides such as a silicon oxide, a silicon nitride, a silicon oxynitride, a silicon carbide, a magnesium oxide, a titanium oxide, a tin oxide, an indium oxide, a zinc oxide and a zirconium oxide, or metal nitrides and carbides thereof.

The lower limit value of the thickness of the vapor-deposited film is preferably equal to or greater than 3 nm, and more preferably equal to or greater than 5 nm. The upper limit value thereof is preferably equal to or less than 100 nm, more preferably equal to or less than 50 nm and particularly preferably equal to or less than 15 nm.

The "aluminum oxide vapor-deposited film" in the present invention means the "vapor-deposited film including an aluminum oxide" as described above, and may include, in addition to an aluminum oxide $Al_2O_3$, an aluminum hydroxide oxide AlO(OH), an aluminum hydroxide $Al(OH)_3$ and the like. Details will be given below.

(Analysis of XAFS spectrum)

The analysis of an XAFS is the analysis of an X-ray absorption fine structure (XAFS) spectrum, and X-rays are applied from the surface side of the vapor-deposited surface of the barrier film (or the side of the covering layer side if the covering layer is provided), and the amount of absorption thereof is measured. The details of measurement conditions and analysis conditions will be described in Examples.

In particular, according to XAFS spectrum analysis of soft X-rays using emitted light, instead of a part of the surface side of the vapor-deposited film, bulk information on the entire vapor-deposited film is obtained, and information on the amount of hydroxyl groups in the aluminum oxide vapor-deposited film is obtained. Even when the covering layer or the like is present on the surface of the vapor-deposited film, X-rays are applied from the surface side of the covering layer to the vapor-deposited film via the covering layer, and thus information on the vapor-deposited film can be obtained in a state where the covering layer is present.

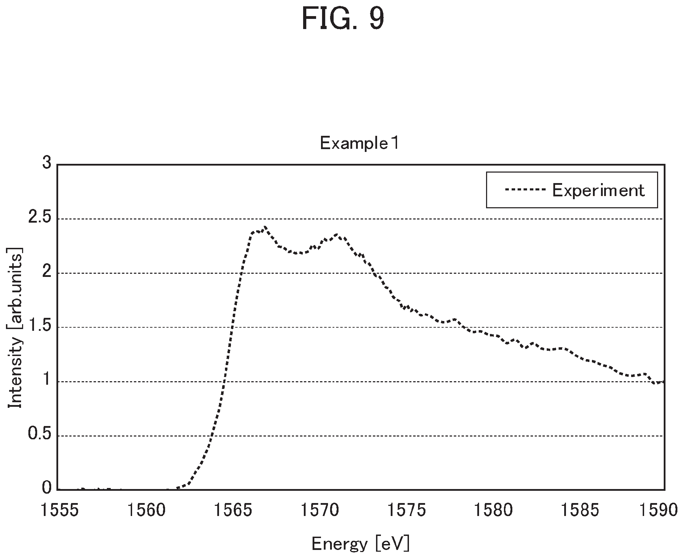

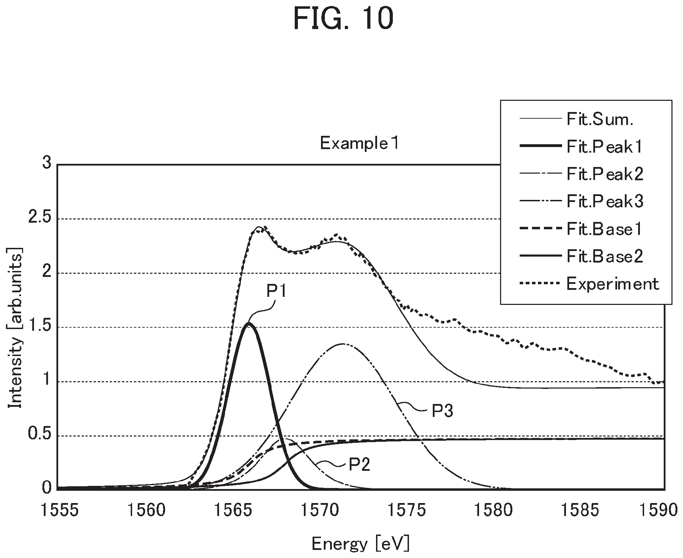

FIG. 9 shows an example of the result of the measurement of an XAFS on a barrier film which will be described later in Example 1. FIG. 10 is a diagram showing peaks obtained by peak separation of an XAFS spectrum in Example 1. In FIGS. 9 and 10, a vertical axis represents an absorption intensity (a. u), and a horizontal axis represents energy (eV). For example, as in FIG. 10, a peak top ratio P in the present invention is a ratio which is determined from peak tops after the peak separation of the XAFS spectrum.

In the peak separation analysis of FIG. 10, Experiment is an actually measured XAFS spectrum, Fit. Peak1 is the intensity peak of 1566 eV separated, Fit. Peak2 is the intensity peak of 1568 eV separated and Fit. Peak3 is the intensity peak of 1572 eV separated. Fit. Base1 is the base line of 1566 eV, and Fit. Base2 is the base line of 1568 eV.

In FIGS. 9 and 10, a plurality of peaks are present in the XAFS spectrum, and specifically, a peak P1 having a top around 1566 eV, a peak P2 having a top around 1568 eV and a peak P3 having a top around 1572 eV are present. The "around 1566 eV" is equal to or greater than 1565 eV and equal to or less than 1567 eV, the "around 1568 eV" is greater than 1567 eV and equal to or less than 1569 eV and the "around 1572 eV" is equal to or greater than 1571 eV and equal to or less than 1573 eV.

Here, it is considered that P1 is a peak derived from a tetracoordinated aluminum oxide, P2 is a peak derived from a hexacoordinated aluminum oxide and P3 is a peak derived from a hexacoordinated aluminum hydroxide and a hexacoordinated aluminum oxide hydroxide.

It is considered that an amorphous aluminum oxide film is superior in flexibility to a crystalline aluminum oxide film, and thus when the aluminum oxide film is used as the barrier film, the aluminum oxide film is preferably amorphous. However, it has been difficult to check whether the aluminum oxide film is crystalline or amorphous using XRD which is a conventional X-ray analysis except in a case where a clear crystalline peak can be checked.

In a case where an XAFS spectrum is checked, when P1 is detected in a crystalline aluminum oxide film, $\gamma$-$Al_2O_3$ and $\theta$-$Al_2O_3$ are present, but the P1 peak is not relatively higher than the P2 peak. In Examples in the present application which will be described later, for example, as in Example 1 (see FIG. 10), P1 > P2 is clear, and thus it is possible to check whether an amorphous film has been formed.

Furthermore, it is considered that as conditions for a flexible aluminum oxide film, being amorphous is not sufficient, and it is necessary to introduce hydroxyl groups. However, for example, in a depth analysis using conventional TOF-SIMS, since it is unclear whether the aluminum oxide film is evaluated or whether moisture left in an interface between the aluminum oxide film and the base material is detected, and it is impossible to obtain a sufficient depth resolution in the part of the aluminum oxide film when the covering layer is provided, it is impossible to fully check a correlation between film formation conditions and the quality of the film.

In the present invention, an XAFS spectrum is checked, peak top ratio P = P3 peak top / P1 peak top = (intensity peak top at around 1572 eV) / (intensity peak top at around 1566 eV) is defined and thus it is possible to obtain information on the amount of hydroxyl groups in the aluminum oxide vapor-deposited film.

In the present invention, it has been found that gas barrier properties are changed depending on the value of the peak top ratio P, specifically, the peak top ratio P is set equal to or greater than 0.70 and less than 1.05 and thus it is possible to maintain barrier properties after the heat sterilization treatment. The lower limit value of the peak top ratio P is preferably equal to or greater than 0.75, and more preferably equal to or greater than 0.80. The upper limit value of the peak top ratio P is preferably equal to or less than 1.00, and more preferably equal to or less than 0.90.

When the peak top ratio P is less than 0.70, the introduction of hydroxyl groups is insufficient, and thus the flexibility of the film is lowered, with the result that gas barrier properties are lowered. Handleability and conveyance properties may be lowered, and oxygen barrier properties may also be lowered especially after retort treatment. When hightemperature and high-humidity wet heat treatment or the like is performed, and thus the peak top ratio P is equal to or greater than 1.05, the introduction of hydroxyl groups is excessive, and thus the initial barrier properties and in particular, the water vapor barrier properties are lowered, with the result that a vapor-deposited film having poor retort resistance is provided.

The peak top ratio P of the barrier film can be adjusted by controlling the combination of plasma pretreatment, plasma assisted treatment during vapor deposition, aging treatment after a film formation step and aging treatment after a covering layer formation step. In particular, a combination is used in which the oxidation of aluminum is facilitated by the plasma assisted treatment during vapor deposition, and then the introduction of hydroxyl groups is facilitated by the aging treatment after the film formation step, with the result that it is possible to obtain high barrier properties even after the retort treatment. The results thereof are supported in Examples which will be described later.

[Covering layer]

The covering layer 130 formed on the vapor-deposited film 120 is a covering layer (barrier coat layer) which protects the vapor-deposited film mechanically and chemically and enhances barrier properties.

The covering layer is formed by applying a barrier coat agent onto the vapor-deposited film and solidifying it. Examples thereof include a cured product of a resin composition which includes an alkoxysilane and a hydroxyl group-containing water-soluble resin (water-soluble polymer), and to which a silane coupling agent, a sol-gel catalyst, an acid and the like are further added as necessary. Another barrier coat agent can be formed using a water-based emulsion or a solvent-based emulsion.

Specific examples of the water-based emulsion include a polyamide emulsion, a polyethylene emulsion, a polyurethane emulsion and the like, and specific examples of the solvent-based emulsion include a polyester emulsion and the like.

As the polyurethane emulsion, for example, a mixed liquid of a polyurethane emulsion and an emulsion of an oxazoline group-containing polymer is preferably used. The polyurethane emulsion may further include a silane coupling agent.

As a metal alkoxide, at least one metal alkoxide represented by a general formula $R1_nM(OR^2)_m$ (where $R_1$ and $R_2$ represent an organic group having 1 to 8 carbon atoms, M represents a metal atom, n represents an integer of 0 or more, m represents an integer of 1 or more and n + m represents the atomic valence of M) can be mentioned as an example, as the metal atom represented by M in the metal alkoxide, silicon, zirconium, titanium, aluminum and the like can be mentioned as examples and for example, it is preferable to use an alkoxysilane in which M is Si.

The alkoxysilane described above is represented by, for example, a general formula $Si(ORa)_4$ (where Ra represents a lower alkyl group). In the formula described above, as Ra, a methyl group, an ethyl group, an n-propyl group, an n-butyl group or the like is used. Specific examples of the alkoxysilane capable of being used include tetramethoxysilane $Si(OCH_3)_4$, tetraethoxysilane $Si(OC_2H_5)_4$, tetrapropoxysilane $Si(OC_3H_7)_4$, tetrabutoxysilane $Si (OC_4H_9)_4$ and the like. Two or more of the alkoxides described above can be used together.

As the silane coupling agent, a silane coupling agent which includes a reactive group such as a vinyl group, an epoxy group, a methacryl group or an amino group can be used. In particular, an organoalkoxysilane including an epoxy group is preferable, and for example, γ-glycidoxypropyltrimethoxysilane, γ-glycidoxypropylmethyldimethoxysilane, γ-glycidoxypropyldimethylmethoxysilane, γ-glycidoxypropyltriethoxysilane, γ-glycidoxypropylmethyldiethoxysilane, γ-glycidoxypropyldimethylethoxysilane, β-(3,4-epoxycyclohexyl)ethyltrimethoxysilane or the like can be used. One, two or more of the silane coupling agents described above may be mixed and used.

In particular, the crosslinking density of the cured film of a covering layer using a bifunctional compound such as γ-glycidoxypropylmethyldimethoxysilane or γ-glycidoxypropylmethyldiethoxysilane is lower than the crosslinking density of a system using a trialkoxysilane. Hence, the film has excellent gas barrier properties and resistance to hot water treatment, and serves as a flexible cured film with excellent bending resistance, and thus the gas barrier properties are unlikely to be lowered.

As the water-soluble polymer, each of a polyvinyl alcohol resin and an ethylene-vinyl alcohol copolymer may be used alone, or a polyvinyl alcohol resin and an ethylene-vinyl alcohol copolymer may be combined and used. In the covering layer according to the present embodiment, a polyvinyl alcohol resin is preferable.

In general, as the polyvinyl alcohol resin, a resin obtained by saponifying polyvinyl acetate can be used. As the polyvinyl alcohol resin, a partially saponified polyvinyl alcohol resin in which several tens of percent of acetate groups are left, a fully saponified polyvinyl alcohol in which no acetate groups are left or a modified polyvinyl alcohol resin in which OH groups are modified may be used. As the polyvinyl alcohol resin, it is necessary to use at least a polyvinyl alcohol resin having a degree of saponification which facilitates the occurrence of crystallization for enhancing the film hardness of a gas barrier coating film, and the degree of saponification is preferably equal to or greater than 70%. A polyvinyl alcohol resin in which the degree of polymerization is within a range (about 100 to 5000) used in a conventional sol-gel method can also be used. Examples of the polyvinyl alcohol resin as described above include a RS resin "RS-110 (degree of saponification = 99%, degree of polymerization = 1,000)" made by Kuraray Co., Ltd., "GOHSENOL NM-14 (degree of saponification = 99%, degree of polymerization = 1,400)" made by Nippon Synthetic Chemical Industry Co., Ltd. and the like.

As the ethylene-vinyl alcohol copolymer, a saponified copolymer of ethylene and vinyl acetate, that is, a product obtained by saponifying an ethylene-vinyl acetate random copolymer can be used. Examples of the ethylene-vinyl alcohol copolymer include a partially saponified product in which several tens of mole percent of acetate groups are left, a partially saponified product in which only a several mole percent of acetate groups are left and a completely saponified product in which no acetate groups are left, and there is no particular limitation. However, in terms of barrier properties, the lower limit value of the degree of saponification is preferably equal to or greater than 80%, more preferably equal to or greater than 90% and further preferably equal to or greater than 95%. The upper limit value is equal to or less than 100%.

As the sol-gel catalyst, an acid or amine compound is preferable.

Examples of the acid capable of being used include mineral acids such as sulfuric acid, hydrochloric acid and nitric acid, and organic acids such as acetic acid, tartaric acid and the like.

The content of the acid is preferably 0.001 to 0.05 mol %, and more preferably 0.01 to 0.03 mol % relative to the total molar amount of alkoxy groups in the metal alkoxide. When the content of the acid is less than 0.001 mol %, a catalytic effect is excessively small whereas when the content of the acid is greater than 0.05 mol %, the catalytic effect is excessively large, and thus a reaction rate is excessively high, with the result that the reaction tends to be non-uniform.

As the amine compound, a tertiary amine which is substantially insoluble in water and is soluble in an organic solvent is preferable. Specific examples of the amine compound capable of being used include N,N-dimethylbenzylamine, tripropylamine, tributylamine, tripentylamine and the like. In particular, N,N-dimethylbenzylamine is preferable.

The content of the amine compound is, for example, 0.01 to 1.0 parts by mass relative to 100 parts by mass of the metal alkoxide, and particularly preferably 0.03 to 0.3 parts by mass. When the content of the amine compound is less than 0.01 parts by mass, a catalytic effect is excessively small whereas when the content of the amine compound is greater than 1.0 part by mass, the catalytic effect is excessively large, and thus a reaction rate is excessively high, with the result that the reaction tends to be non-uniform.

Examples of the solvent which is preferably used include water, alcohols such as methyl alcohol, ethyl alcohol, n-propyl alcohol, isopropanol and n-butanol and the like.

The thickness of the barrier covering layer formed as described above is 100 to 500 nm, and preferably 200 to 400 nm. This range is preferable because the coating film does not crack and the surface of the vapor-deposited film is sufficiently coated.

When a silane coupling agent is contained, in the composition of the barrier coat agent, a water-soluble polymer such as a polyvinyl alcohol resin can be used in a range of 5 to 10 parts by mass relative to 100 parts by mass of the alkoxysilane, and the silane coupling agent can be used in a range of 1 to 10 parts by mass relative to 100 parts by mass of the alkoxysilane. In this way, it is possible to maintain the flexibility of the film. In the range described above, when the usage of the silane coupling agent exceeds 20 parts by mass, the rigidity and brittleness of the resulting barrier coating film are undesirably excessive.

When no silane coupling agent is contained, a water-soluble polymer such as a polyvinyl alcohol resin is used in a range of 10 to 20 parts by mass relative to 100 parts by mass of the alkoxysilane, and thus the ratio of the amount of metal alkoxide is lowered, with the result that it is possible to enhance barrier properties.

In the covering layer, the lower limit value of the ratio of the mass of the metal alkoxide such as tetraethoxysilane in terms of $SiO_2$ to the mass of a water-soluble resin such as polyvinyl alcohol is preferably equal to or greater than 1.6, and more preferably equal to or greater than 1.9. The upper limit value thereof is preferably equal to or less than 3.9, and more preferably equal to or less than 3.5. The ratio exceeding 3.9 is not preferable because barrier properties may be lowered in subsequent steps or the like, and the ratio below 1.6 is not preferable because barrier properties after the retort treatment are lowered.

The ratio of silicon atoms to carbon atoms (Si/C) in the covering layer is preferably equal to or greater than 1.30 and equal to or less than 1.65. The ratio exceeding 1.65 is not preferable because barrier properties may be lowered in subsequent steps or the like, and the ratio below 1.30 is not preferable because barrier properties after the heat sterilization treatment are lowered. The ratio of silicon atoms to carbon atoms in the covering layer can be measured by X-ray photoelectron spectroscopy (XPS), and specifically, can be measured under conditions described in Examples.

(Film formation device)

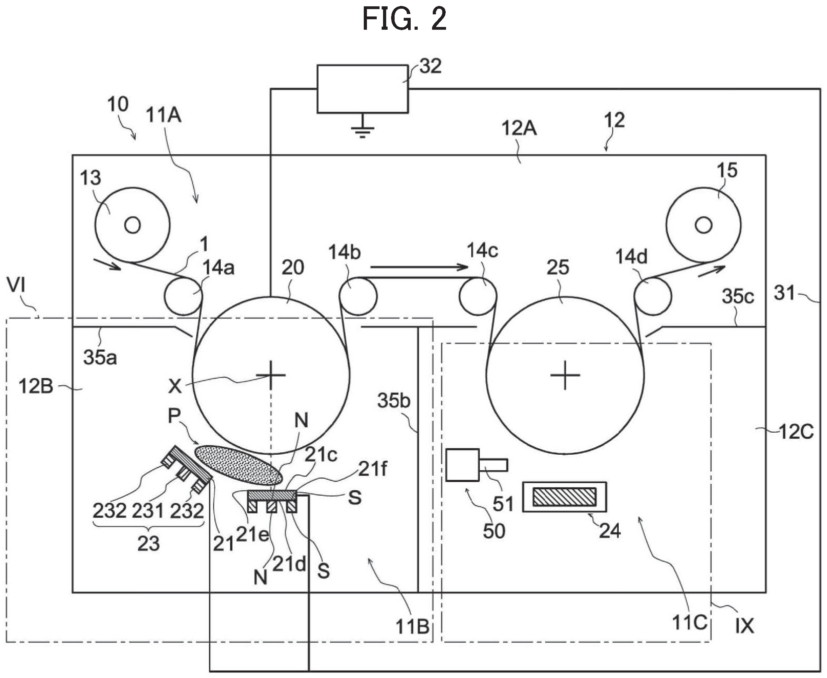

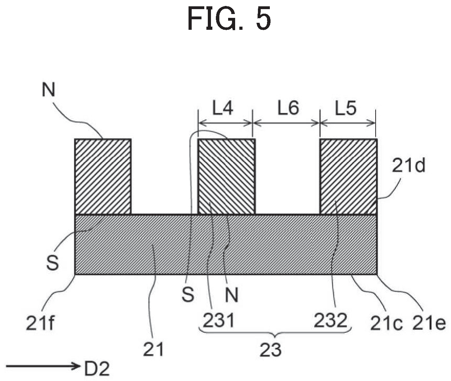

An example of a film formation device 10 used in the manufacturing of the barrier film will then be described. As shown in FIG. 2, the film formation device 10 includes a base material conveyance mechanism 11A for conveying a base material 1, a plasma pretreatment mechanism 11B for performing the plasma pretreatment on the surface of the base material 1 and a film formation mechanism 11C for forming a vapor-deposited film 2. In the example shown in FIG. 5, the film formation device 10 further includes a decompression chamber 12. The decompression chamber 12 includes a decompression mechanism, such as a vacuum pump to be described later, which adjusts an atmosphere in at least a part of a space inside the decompression chamber 12 to a pressure equal to or lower than atmospheric pressure.

In the example shown in FIG. 2, the decompression chamber 12 includes a base material conveyance chamber 12A in which the base material conveyance mechanism 11A is located, a plasma pretreatment chamber 12B in which the plasma pretreatment mechanism 11B is located and a film formation chamber 12C in which the film formation mechanism 11C is located. The decompression chamber 12 is preferably configured to suppress the mixing of atmospheres inside the chambers. For example, as shown in FIG. 2, the decompression chamber 12 may include partition walls 35a to 35c which are located between the base material conveyance chamber 12A and the plasma pretreatment chamber 12B, between the plasma pretreatment chamber 12B and the film formation chamber 12C and between the base material conveyance chamber 12A and the film formation chamber 12C to separate the chambers.

The base material conveyance chamber 12A, the plasma pretreatment chamber 12B and the film formation chamber 12C will be described. Each of the plasma pretreatment chamber 12B and the film formation chamber 12C is provided in contact with the base material conveyance chamber 12A, and includes a part which is connected to the base material conveyance chamber 12A. In this way, the base material 1 can be conveyed without being in contact with the atmosphere between the base material conveyance chamber 12A and the plasma pretreatment chamber 12B and between the base material conveyance chamber 12A and the film formation chamber 12C. For example, between the base material conveyance chamber 12A and the plasma pretreatment chamber 12B, the base material 1 can be conveyed via an opening provided in the partition wall 35a. The same structure is provided between the base material conveyance chamber 12A and the film formation chamber 12C, and thus the base material 1 can be conveyed between the base material conveyance chamber 12A and the film formation chamber 12C.

The function of the decompression mechanism of the decompression chamber 12 will be described. The decompression mechanism of the decompression chamber 12 is configured to be able to reduce an atmosphere in a space of the film formation device 10 where at least the plasma pretreatment mechanism 11B or the film formation mechanism 11C is disposed to a pressure equal to or lower than atmospheric pressure. The decompression mechanism may be configured to be able to reduce an atmosphere in each of the base material conveyance chamber 12A, the plasma pretreatment chamber 12B and the film formation chamber 12C separated by the partition walls 35a to 35c to a pressure equal to or lower than atmospheric pressure.

The configuration of the decompression mechanism of the decompression chamber 12 will be described. The decompression chamber 12 may include, for example, a vacuum pump connected to the plasma pretreatment chamber 12B. The vacuum pump is adjusted, and thus it is possible to appropriately control a pressure in the plasma pretreatment chamber 12B when the plasma pretreatment which will be described later is performed. By a method which will be described later, it is possible to suppress diffusion of plasma supplied into the plasma pretreatment chamber 12B to the other chambers. The decompression mechanism of the decompression chamber 12 may include a vacuum pump connected to the film formation chamber 12C as with the vacuum pump connected to the plasma pretreatment chamber 12B. Examples of the vacuum pump capable of being used include a dry pump, a turbomolecular pump, a cryopump, a rotary pump, a diffusion pump and the like.

The base material conveyance mechanism 11A of the base material 1 in the film formation device 10 according to the present embodiment will be described together with the conveyance path of the base material 1. The base material conveyance mechanism 11A is a mechanism for conveying the base material 1 disposed in the base material conveyance chamber 12A. In the example shown in FIG. 2, the base material conveyance mechanism 11A includes an unwinding roller 13 to which a roll of original fabric of the base material 1 is attached, a winding roller 15 which winds up the base material 1 and guide rolls 14a to 14d. The base material 1 fed out from the base material conveyance mechanism 11A is then conveyed by a pretreatment roller 20 which is disposed in the plasma pretreatment chamber 12B and will be described later and a film formation roller 25 which is disposed in the film formation chamber 12C and will be described later.

The base material conveyance mechanism 11A may further include a tension pickup roller which is not shown in the figure. The base material conveyance mechanism 11A includes the tension pickup roller, and thus the base material 1 can be conveyed while tension applied to the base material 1 is being adjusted.

(Plasma pretreatment mechanism)

The plasma pretreatment mechanism 11B will be described. The plasma pretreatment mechanism 11B is a mechanism for performing the plasma pretreatment on the surface of the base material 1. The plasma pretreatment mechanism 11B shown in FIG. 2 generates the plasma P, and uses the generated plasma P to perform the plasma pretreatment on the surface of the base material 1. When the surface of the base material 1 is activated by the plasma pretreatment, for example, hydrogen is released from the resin component of the base material, and thus carbon radicals are generated. Thereafter, the carbon radicals combine with oxygen or hydrogen in the atmosphere, and thus functional groups such as a hydroxyl group, a carboxyl group and a ketone group are generated. It is considered that the functional groups as described above are generated, and thus adhesion between the base material 1 and the vapor-deposited film 2 is enhanced. The plasma pretreatment mechanism 11B shown in FIG. 2 includes the pretreatment roller 20 disposed in the plasma pretreatment chamber 12B, an electrode unit 21 opposite the plasma pretreatment chamber 12B and a magnetic field formation unit 23 which forms a magnetic field between the pretreatment roller 20 and the electrode unit 21.

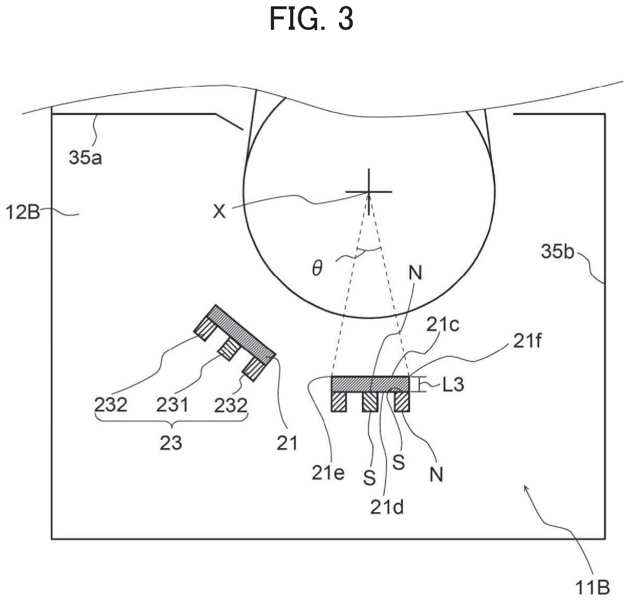

The pretreatment roller 20 will be described. FIG. 3 is an enlarged view of a part enclosed by alternate long and short dashed lines and identified with a symbol VI in FIG. 2. In FIG. 3, a power supply wire 31 which connects a power supply 32 shown in FIG. 2 and the electrode unit 21 which will be described later and the plasma P generated by the plasma pretreatment mechanism 11B are omitted. The pretreatment roller 20 includes a rotation axis X. The pretreatment roller 20 is provided such that at least the rotation axis X is located in the plasma pretreatment chamber 12B separated by the partition walls 35a and 35b. The base material 1 having a dimension in the direction of the rotation axis X is wound around the pretreatment roller 20. In the following description, the dimension of the base material 1 in the direction of the rotation axis X is also referred to as the width of the base material 1. The direction of the rotation axis X is also referred to as the width direction of the base material 1.

As shown in FIG. 2, the pretreatment roller 20 may be provided such that a part of the pretreatment roller 20 is exposed to the side of the base material conveyance chamber 12A. In the example shown in FIG. 2, the plasma pretreatment chamber 12B and the base material conveyance chamber 12A are connected via the opening provided in the partition wall 35a, and the part of the pretreatment roller 20 is exposed to the side of the base material conveyance chamber 12A through the opening. A gap is provided between the partition wall 35a between the base material conveyance chamber 12A and the plasma pretreatment chamber 12B and the pretreatment roller 20, and the base material 1 can be conveyed from the base material conveyance chamber 12A to the plasma pretreatment chamber 12B through the gap. Although not shown in the figure, the pretreatment roller 20 may be provided such that the entire pretreatment roller 20 is located in the plasma pretreatment chamber 12B.

The pretreatment roller 20 may include an unillustrated temperature adjustment mechanism which adjusts the temperature of the surface of the pretreatment roller 20. For example, the pretreatment roller 20 may include, in the pretreatment roller 20, the temperature adjustment mechanism which includes piping for circulating a temperature adjustment medium such as a refrigerant or a heat medium. The temperature adjustment mechanism adjusts the temperature of the surface of the pretreatment roller 20 to a target temperature within, for example, a range equal to or greater than -20°C and equal to or less than 100°C.

The pretreatment roller 20 includes the temperature adjustment mechanism, and thus it is possible to suppress shrinkage or damage of the base material 1 caused by heat during the plasma pretreatment.

The pretreatment roller 20 is formed of a material which includes at least one or more of stainless steel, iron, copper and chromium. The surface of the pretreatment roller 20 may be subjected to hard chrome hard coat treatment or the like so that a scratch is prevented. These materials are easily processed. As the material of the pretreatment roller 20, the material described above is used, and thus the thermal conductivity of the pretreatment roller 20 itself is enhanced, with the result that it is easy to control the pretreatment roller 20.

The electrode unit 21 will be described. In the example shown in FIGS. 2 and 3, the electrode unit 21 includes a first surface 21c opposite the pretreatment roller 20 and a second surface 21d located on a side opposite to the first surface 21c. In the example shown in FIGS. 2 and 3, the electrode unit 21 is a plate-shaped member, and the first surface 21c and the second surface 21d are flat surfaces. The electrode unit 21 applies an alternating-current voltage to an area between the pretreatment roller 20 and the electrode unit 21, and thus the plasma is generated between the pretreatment roller 20 and the electrode unit 21. Preferably, the electrode unit 21 forms an electric field such that the plasma generated between the pretreatment roller 20 and the electrode unit 21 moves toward the surface of the base material 1 in a direction perpendicular to the surface of the base material 1. In this way, it is possible to efficiently pretreat the base material 1.

The number of electrode units 21 is preferably two or more. Two or more electrode units 21 are preferably arranged along the conveyance direction of the base material 1. In the example shown in FIGS. 2 and 3, the film formation device 10 includes two electrode units 21. The number of electrode units 21 is, for example, twelve or less.

An effect caused by the fact that two or more electrode units 21 are arranged along the conveyance direction of the base material 1 will be described. As described above, the plasma is generated between the electrode unit 21 and the pretreatment roller 20. A region where the plasma is generated is enlarged as the dimension of the electrode unit 21 in the conveyance direction is increased. On the other hand, when the electrode unit 21 is a plate-shaped flat member, as the dimension of the electrode unit 21 in the conveyance direction is increased, a distance from an end portion of the first surface 21c opposite the pretreatment roller 20 in the electrode unit 21 in the conveyance direction to the pretreatment roller 20 is increased, with the result that a treatment capacity caused by the plasma is lowered.

In the film formation device 10, two or more electrode units 21 are arranged along the conveyance direction of the base material 1. Hence, even when the dimension of the electrode unit 21 in the conveyance direction of the base material 1 is small, the plasma can be generated over a wide range in the conveyance direction. The dimension of the electrode unit 21 is decreased, and thus it is possible to decrease the distance from the end portion of the first surface 21c of the electrode unit 21 in the conveyance direction to the pretreatment roller 20, with the result that the plasma can be generated uniformly in the conveyance direction.

As shown in FIGS. 2 and 3, the electrode unit 21 includes a first end portion 21e and a second end portion 21f which are located on the first surface 21c of the electrode unit 21. The first end portion 21e is an end portion on an upstream side in the conveyance direction of the base material 1, and the second end portion 21f is an end portion on a downstream side in the conveyance direction of the base material 1. As described above, the dimension of the electrode unit 21 in the conveyance direction of the base material 1 is decreased, and thus it is possible to decrease the distance from the first end portion 21e and the second end portion 21f of the electrode unit 21 in the conveyance direction to the pretreatment roller 20. The dimension of the electrode unit 21 in the conveyance direction of the base material 1 corresponds to an angle $\theta$ shown in FIG. 3. The angle $\theta$ is an angle formed by a straight line passing through the first end portion 21e and the rotation axis X and a straight line passing through the second end portion 21f and the rotation axis X. The angle $\theta$ is preferably equal to or greater than 20° and equal to or less than 90°, more preferably equal to or less than 60° and further preferably equal to or less than 45°. The angle $\theta$ falls in the range described above, and thus when the first surface 21c of the electrode unit 21 is a flat surface, the plasma can be generated uniformly between the electrode unit 21 and the pretreatment roller 20 in the conveyance direction.

The material of the electrode unit 21 is not particularly limited as long as the material is conductive. Specifically, as the material of the electrode unit 21, aluminum, copper or stainless steel is preferably used.

Although the thickness L3 of the electrode unit 21 when viewed in a direction perpendicular to the first surface 21c of the electrode unit 21 is not particularly limited, the thickness L3 is, for example, 15 mm or less. The thickness of the electrode unit 21 is the value described above, and thus a magnetic field can be effectively formed between the pretreatment roller 20 and the electrode unit 21 by the magnetic field formation unit 23. The thickness L3 of the electrode unit 21 is, for example, 3 mm or more.

The magnetic field formation unit 23 will be described. As shown in FIGS. 2 and 3, the magnetic field formation unit 23 is provided on a side opposite to the side opposite the pretreatment roller 20, of the electrode unit 21. The magnetic field formation unit 23 is a member which forms a magnetic field between the pretreatment roller 20 and the electrode unit 21. For example, when the plasma is generated using the plasma pretreatment mechanism 11B, the magnetic field between the pretreatment roller 20 and the electrode unit 21 contributes to the generation of the higher-density plasma. The magnetic field formation unit 23 shown in FIGS. 2 and 3 includes a first magnet 231 and a second magnet 232 provided on the second surface 21d of the electrode unit 21.

The number of magnetic field formation units 23 is preferably two or more. Preferably, when the plasma pretreatment mechanism 11B includes two or more electrode units 21 and two or more magnetic field formation units 23, the two or more magnetic field formation units 23 are respectively provided on the sides of the two or more electrode units 21 opposite to the sides opposite the pretreatment roller 20. In the example shown in FIGS. 2 and 3, the two magnetic field formation units 23 are respectively provided on the second surfaces 21d of the two electrode units 21.

The structure of the first magnet 231 and the second magnet 232 in the normal direction of the second surface 21d of the electrode unit 21 will be described. As shown in FIGS. 2 and 3, each of the first magnet 231 and the second magnet 232 includes a north pole and a south pole. A symbol N shown in FIGS. 2 and 3 represents the north pole of the first magnet 231 or the second magnet 232. A symbol S shown in FIGS. 2 and 3 represents the south pole of the first magnet 231 or the second magnet 232. One of the north pole and the south pole of the first magnet 231 is located on the side of the base material 1 relative to the other. The other of the north pole and the south pole of the second magnet 232 is located on the side of the base material 1 relative to one of them. In the example shown in FIGS. 2 and 3, the north pole of the first magnet 231 is located on the side of the base material 1 relative to the south pole of the first magnet 231, and the south pole of the second magnet 232 is located on the side of the base material 1 relative to the north pole of the second magnet. Although not shown in the figure, the south pole of the first magnet 231 may be located on the side of the base material 1 relative to the north pole of the first magnet 231, and the north pole of the second magnet 232 may be located on the side of the base material 1 relative to the second magnet 232.

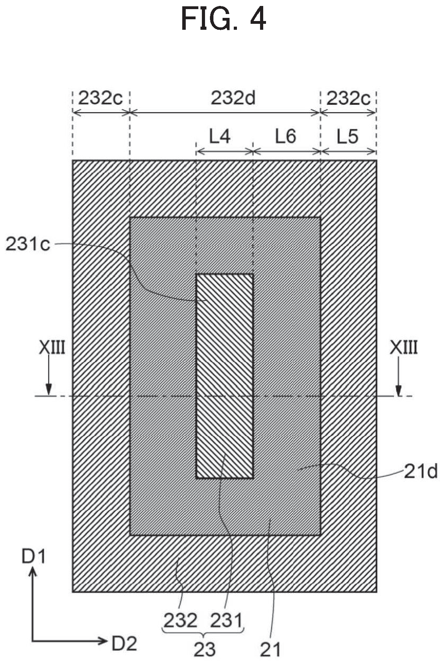

Then, the structure of the first magnet 231 and the second magnet 232 in the direction of the second surface 21d of the electrode unit 21 will be described. FIG. 4 is a plan view when the electrode unit 21 and the magnetic field formation unit 23 shown in FIG. 2 are viewed from the side of the magnetic field formation unit 23. FIG. 5 is a cross-sectional view taken along line VIII-VIII in FIG. 4. In FIG. 4, a direction D1 is a direction in which the rotation axis X of the pretreatment roller 20 extends.

As shown in FIGS. 4 and 5, the first magnet 231 includes a first axial part 231c. As shown in FIG. 4, the first axial part 231c extends along the direction D1, that is, along the rotation axis X of the pretreatment roller 20. The first magnet 231 provided in one electrode unit 21 may include one first axial part 231c, or may include two or more first axial parts 231c. In the example shown in FIG. 4, the first magnet 231 provided in one electrode unit 21 includes one first axial part 231c.

As shown in FIGS. 4 and 5, the second magnet 232 includes a second axial part 232c. As shown in FIG. 4, as with the first axial part 231c, the second axial part 232c extends along the direction D1, that is, the rotation axis X.

Each of the first magnet 231 and the second magnet 232 includes a part extending along the rotation axis X, and thus it is possible to enhance the uniformity in the width direction of the base material 1 of the intensity of a magnetic field formed around the base material 1. In this way, it is possible to enhance the uniformity in the width direction of the base material 1 of the distribution density of the plasma formed around the base material 1.

The second magnet 232 provided in one electrode unit 21 may include one second axial part 232c, or may include two or more second axial parts 232c. In the example shown in FIGS. 4 and 5, the second magnet 232 provided in one electrode unit 21 includes two second axial parts 232c. The two second axial parts 232c may be located to sandwich the first axial part 231c in a direction D2 orthogonal to the rotation axis X in the direction of the second surface 21d of the electrode unit 21.

The dimension L4 of the first axial part 231c and the dimension L5 of the second axial part 232c in the conveyance direction of the base material 1 shown in FIG. 5 are not particularly limited. The ratio between the dimension L4 of the first axial part 231c and the dimension L5 of the second axial part 232c in the conveyance direction of the base material 1 is not particularly limited. The dimension L4 of the first axial part 231c may be equal to the dimension L5 of the second axial part 232c, and the dimension L4 of the first axial part 231c may be larger than the dimension L5 of the second axial part 232c.

A distance L6 between the first axial part 231c and the second axial part 232c in the direction D2 is set such that the magnetic field generated by the first axial part 231c and the second axial part 232c is formed between the pretreatment roller 20 and the electrode unit 21.

When the magnetic field formation unit 23 is viewed along the normal direction of the second surface 21d of the electrode unit 21, the second magnet 232 may surround the first magnet 231. For example, as shown in FIG. 4, the second magnet 232 may include, together with the two second axial parts 232c, two connection parts 232d provided to connect the two second axial parts 232c.

Examples of types of magnets used as the magnetic field formation unit 23 such as the first magnet 231 and the second magnet 232 include permanent magnets such as a ferrite magnet and rare earth magnets such as neodymium and samarium cobalt. As the magnetic field formation unit 23, an electromagnet can be used.

The magnetic flux density of the magnets of the magnetic field formation unit 23 such as the first magnet 231 and the second magnet 232 is, for example, equal to or greater than 100 gauss and equal to or less than 10000 gauss. When the magnetic flux density is equal to or greater than 100 gauss, a sufficiently strong magnetic field is formed between the pretreatment roller 20 and the electrode unit 21, and thus it is possible to generate sufficiently high-density plasma, with the result that a satisfactory pretreatment surface can be formed at high speed. On the other hand, in order to increase the magnetic flux density on the surface of the base material 1 beyond 10000 gauss, an expensive magnet or a magnetic field generation mechanism is required.

The plasma pretreatment mechanism 11B may include an unillustrated plasma raw material gas supply unit. The plasma raw material gas supply unit supplies a gas serving as the raw material of the plasma into the plasma pretreatment chamber 12B. The configuration of the plasma raw material gas supply unit is not particularly limited. For example, the plasma raw material gas supply unit is provided on the wall surface of the plasma pretreatment chamber 12B, and includes a hole for ejecting the gas serving as the raw material of the plasma. The plasma raw material gas supply unit may include a nozzle which discharges the plasma raw material gas in a position closer to the base material 1 than to the wall surface of the plasma pretreatment chamber 12B. Examples of the plasma raw material gases supplied by the plasma raw material gas supply unit include inert gases such as argon, active gases such as oxygen, nitrogen, carbon dioxide and ethylene or a mixture of these gases. As the plasma raw material gas, one of the inert gases may be used alone, one of the active gases may be used alone or a mixed gas of two or more gases included in the inert gases or the active gases may be used. As the plasma raw material gas, a mixed gas of an inert gas such as argon and an active gas is preferably used. In one example, the plasma raw material gas supply unit supplies a mixed gas of argon (Ar) and oxygen ($O_2$).

The plasma pretreatment mechanism 11B supplies, for example, plasma having a plasma density which is equal to or greater than 100 W·sec/m$^2$ and equal to or less than 8000 W·sec/m$^2$ to the area between the pretreatment roller 20 and the electrode unit 21.

In the example shown in FIG. 2, the plasma pretreatment mechanism 11B is disposed in the plasma pretreatment chamber 12B separated by partition walls from the base material conveyance chamber 12A and the film formation chamber 12C. The plasma pretreatment chamber 12B is separated from other regions such as the base material conveyance chamber 12A and the film formation chamber 12C, and thus an atmosphere in the plasma pretreatment chamber 12B is adjusted individually and easily. In this way, for example, it is easy to control the concentration of the plasma raw material gas in a space through which the pretreatment roller 20 is opposite the electrode unit 21, and thus the productivity of the multilayer film is enhanced.

(Film formation mechanism)

The film formation mechanism 11C will then be described. In the example shown in FIG. 2, the film formation mechanism 11C includes the film formation roller 25 disposed in the film formation chamber 12C and an evaporation mechanism 24.

The film formation roller 25 will be described. The film formation roller 25 is a roller which winds and conveys the base material 1 with the surface of the base material 1 pretreated in the plasma pretreatment mechanism 11B facing outward.

The material of the film formation roller 25 will be described. The film formation roller 25 is preferably formed of a material which includes at least one or more of stainless steel, iron, copper and chromium. The surface of the film formation roller 25 may be subjected to hard chrome hard coat treatment or the like so that a scratch is prevented. These materials are easily processed. As the material of the film formation roller 25, the material described above is used, and thus the thermal conductivity of the film formation roller 25 itself is enhanced, with the result that when temperature control is performed, temperature controllability is excellent. The average surface roughness Ra of the surface of the film formation roller 25 is, for example, equal to or greater than 0.1 $\mu$m and equal to or less than 10 $\mu$m.

The film formation roller 25 may include an unillustrated temperature adjustment mechanism which adjusts the temperature of the surface of the film formation roller 25. For example, the temperature adjustment mechanism may include, in the film formation roller 25, a circulation path for circulating a cooling medium or a heat source medium. The cooling medium (refrigerant) is, for example, an ethylene glycol aqueous solution, and the heat source medium (heat medium) is, for example, silicone oil. The temperature adjustment mechanism may include a heater which is installed in a position opposite the film formation roller 25. When the film formation mechanism 11C forms the film by a vapor deposition method, in terms of the heat resistance restriction and versatility of related mechanical components, the temperature adjustment mechanism preferably adjusts the temperature of the surface of the film formation roller 25 to a target temperature within a range equal to or greater than -20°C and equal to or less than 200°C. The film formation roller 25 includes the temperature adjustment mechanism, and thus it is possible to suppress a variation in the temperature of the base material 1 caused by heat generated when the film is formed.

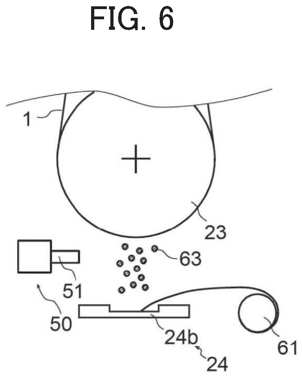

The evaporation mechanism 24 will be described. FIG. 6 is an enlarged view of a part enclosed by alternate long and short dashed lines and identified with a symbol IX in FIG. 2, and is also a diagram showing a specific form of the evaporation mechanism 24 omitted in FIG. 5 and a vapor deposition material supply unit 61 which supplies a vapor deposition material and is omitted in FIG. 5. In FIG. 6, the decompression chamber 12 and the partition walls 35b and 35c are omitted. The evaporation mechanism 24 is a mechanism for evaporating the vapor deposition material including aluminum. The evaporated vapor deposition material is adhered to the base material 1, and thus the vapor-deposited film including aluminum is formed on the surface of the base material 1. The evaporation mechanism 24 in the present embodiment adopts a resistance heating type. In the example shown in FIG. 6, the evaporation mechanism 24 includes a boat 24b. In the present embodiment, the boat 24b includes an unillustrated power supply and an unillustrated resistor which is electrically connected to the power supply. A plurality of boats 24b may be arranged in the width direction of the base material 1.

As shown in FIG. 6, the film formation mechanism 11C may include the vapor deposition material supply unit 61 which supplies the vapor deposition material to the evaporation mechanism 24. FIG. 6 shows an example where the vapor deposition material supply unit 61 continuously feeds an aluminum metal wire.

The film formation mechanism 11C includes an unillustrated gas supply mechanism. The gas supply mechanism is a mechanism for supplying a gas to an area between the evaporation mechanism 24 and the film formation roller 25. The gas supply mechanism supplies at least oxygen gas. The oxygen gas reacts with or combines with the evaporation material such as aluminum evaporated from the evaporation mechanism 24 and moved toward the base material 1 on the film formation roller 25. In this way, it is possible to form the vapor-deposited film including aluminum on the surface of the base material 1.

The film formation mechanism 11C includes a plasma supply mechanism 50 which supplies the plasma to an area between the surface of the base material 1 and the evaporation mechanism 24. In the example shown in FIGS. 2 and 6, the plasma supply mechanism 50 includes a hollow cathode 51. In the present embodiment, the hollow cathode 51 is a cathode including a hollow portion which is partially open. The hollow cathode 51 can generate the plasma inside the hollow portion. In the example shown in FIG. 6, the hollow cathode 51 is provided such that the opening of the hollow portion of the hollow cathode 51 is located obliquely above the boat 24b. The plasma supply mechanism 50 according to the present embodiment includes an unillustrated anode which draws the plasma from the opening of the hollow portion of the hollow cathode 51 and is opposite the opening. The plasma supply mechanism 50 according to the present embodiment generates the plasma inside the hollow portion of the hollow cathode 51, draws, with the opposite anode, the plasma to the area between the surface of the base material 1 and the evaporation mechanism 24 and thereby generates the strong plasma between the surface of the base material 1 and the evaporation mechanism 24. The position of the opposite anode is not particularly limited as long as it is possible to draw, with the opposite anode, the plasma from the opening of the hollow portion of the hollow cathode 51, and to supply the plasma to the area between the surface of the base material 1 and the evaporation mechanism 24. In the present embodiment, a case where the opposite anodes are arranged on both sides of the boats 24b in the width direction of the base material 1 will be described. In this case, the film formation mechanism 11C includes a plurality of boats 24b and a plurality of opposite anodes, and the boats 24b and the opposite anodes may be alternately arranged in the width direction of the base material 1. The plasma supply mechanism 50 may include an unillustrated raw material supply device which supplies at least the plasma raw material gas into the hollow portion of the hollow cathode 51. As the plasma raw material gas supplied by the raw material supply device, for example, the same gas as the gas which is supplied by the plasma raw material gas supply unit of the plasma pretreatment mechanism 11B and can be used as the plasma raw material gas can be used.

The plasma supply mechanism 50 performs plasma assistance during the vapor deposition for supplying the plasma to the area between the surface of the base material 1 and the evaporation mechanism 24, and thereby can activate aluminum and oxygen gas evaporated in the evaporation mechanism 24 to facilitate the reaction or combination of the aluminum and the oxygen gas. In this way, it is possible to increase the ratio of aluminum present as an aluminum oxide in the vapor-deposited film 2 formed on the surface of the base material 1, and to stabilize the properties of the vapor-deposited film 2.

The film formation device 10 may include, in a part of the base material conveyance chamber 12A located on a downstream side in the conveyance direction of the base material 1 relative to the film formation chamber 12C, an unillustrated base material charge removal unit which performs post-treatment for removing charge generated on the base material 1 due to the film formation performed by the film formation mechanism 11C. The base material charge removal unit may be provided to remove charge on one side of the base material 1, or may be provided to remove charge on both sides of the base material 1.

Although a device which is used as the base material charge removal unit for performing the post-treatment on the base material 1 is not particularly limited, examples of the device capable of being used include a plasma discharge device, an electron beam application device, an ultraviolet application device, a static elimination bar, a glow discharge device, a corona treatment device and the like.

When a plasma treatment device and the glow discharge device are used to form discharge, and thus the post-treatment is performed, a discharge gas such as argon, oxygen, nitrogen or helium or a mixed gas of these gases is supplied to an area near the base material 1, and the post-treatment can be performed using any discharge method such as alternating current (AC) plasma, direct current (DC) plasma, arc discharge, microwave or surface wave plasma. In a reducedpressure environment, it is most preferable to perform the post-treatment using the plasma discharge device.

The base material charge removal unit is installed in a part of the base material conveyance chamber 12A located on the downstream side in the conveyance direction of the base material 1 relative to the film formation chamber 12C, and thus charge on the base material 1 is removed, with the result that the base material 1 can be rapidly separated from the film formation roller 25 at a predetermined position and conveyed. Hence, it is possible to stably convey the base material, damage to the base material 1 and a decrease in quality caused by charge are prevented and thus the wettability of the front and back surfaces of the base material is improved, with the result that post-processability can be enhanced.

(Power supply)

In the example shown in FIG. 2, the film formation device 10 further includes the power supply 32 which is electrically connected to the pretreatment roller 20 and the electrode unit 21. In the example shown in FIG. 5, the power supply 32 is electrically connected via the power supply wire 31 to the pretreatment roller 20 and the electrode unit 21. The power supply 32 is, for example, an alternating-current power supply. When the power supply 32 is an alternating-current power supply, the power supply 32 can apply, for example, an alternating-current voltage having a frequency equal to or greater than 20 kHz and equal to or less than 500 kHz to the area between the pretreatment roller 20 and the electrode unit 21. Although input power which can be applied by the power supply 32 (power which can be applied per 1 m of the width of the electrode unit 21 in the width direction of the base material 1) is not particularly limited, the input power is, for example, equal to or greater than 0.5 kW/m and equal to or less than 20 kW/m. The pretreatment roller 20 may be installed at an electrical ground level or at an electrical floating level.

(Method for manufacturing barrier film)

A method for manufacturing the barrier film shown in FIG. 1 using the film formation device 10 described above will then be described. A method for forming the vapor-deposited film 2 on the surface of the base material 1 will first be described. In the film formation using the film formation device 10, a plasma pretreatment step of performing the plasma pretreatment on the surface of the base material 1 using the plasma pretreatment mechanism 11B while conveying the base material 1 along the conveyance path of the base material 1 described above and the film formation step of forming the vapor-deposited film on the surface of the base material 1 using the film formation mechanism 11C are performed. The conveyance speed of the base material 1 is preferably equal to or greater than 200 m/min, and more preferably equal to or greater than 400 m/min and equal to or less than 1000 m/min.

(Plasma pretreatment step)

The plasma pretreatment step is performed by, for example, the following method. The plasma raw material gas is first supplied into the plasma pretreatment chamber 12B. The alternating-current voltage described above is then applied to the area between the pretreatment roller 20 and the electrode unit 21. When the alternating-current voltage is applied, input power control, impedance control or the like may be performed.

The plasma raw material gas supplied in the pretreatment is oxygen alone or a mixed gas of oxygen gas and an inert gas, and is supplied from a gas reservoir unit via a flow rate controller while the flow rate of the gas is being measured. Examples of the inert gas include a mixed gas of one or two or more selected from the group consisting of argon, helium and nitrogen.

In the plasma treatment, the mixing ratio of oxygen gas to the inert gas, that is, oxygen gas / inert gas is preferably 6/1 to 1/1, and more preferably 5/2 to 3/2.5.

The mixing ratio is set to 6/1 to 1/1, and thus the film formation energy of the vapor-deposited aluminum on a resin base material is increased, and furthermore, the mixing ratio is set to 5/2 to 3/2 to increase the oxidation degree of the aluminum oxide vapor-deposited film, and thus it is possible to ensure adhesion between the aluminum oxide vapor-deposited film and the base material.

The alternating-current voltage is applied, and thus the plasma is generated simultaneously with glow discharge, with the result that the density of the plasma P between the pretreatment roller 20 and the magnetic field formation unit 23 is increased. In this way, it is possible to supply the plasma P to an area between the pretreatment roller 20 and the magnetic field formation unit 23. By the plasma P described above, the plasma (ion) pretreatment can be performed on the surface of the base material 1.

A plasma intensity per unit area in the plasma treatment is equal to or greater than 50 W·sec/m$^2$ and equal to or less than 8000 W·sec/m$^2$, and when the plasma intensity is equal to or less than 50 W·sec/m$^2$, the effect of the plasma pretreatment is not found whereas when the plasma intensity is equal to or greater than 8000 W·sec/m$^2$, deterioration of the resin base material such as wear, damage, discoloration and burning of the resin base material tends to occur. In particular, the plasma intensity in the plasma pretreatment for forming into an aluminum oxide layer is preferably equal to or greater than 100 W·sec/m$^2$ and equal to or less than 1000 W·sec/m$^2$.

When the alternating-current voltage is applied to the area between the pretreatment roller 20 and the electrode unit 21, a pressure in the plasma pretreatment chamber 12B is reduced by the decompression chamber 12 to a pressure equal to or lower than atmospheric pressure. In this case, the pressure in the plasma pretreatment chamber 12B is adjusted such that for example, the application of the alternating-current voltage allows the generation of glow discharge between the pretreatment roller 20 and the electrode unit 21. When the alternating-current voltage is applied to the area between the pretreatment roller 20 and the electrode unit 21, the pressure in the plasma pretreatment chamber 12B can be set or maintained approximately equal to or greater than 0.1 Pa and equal to or less than 100 Pa, and is particularly preferably equal to or greater than 1 Pa and equal to or less than 20 Pa.

The function of the magnetic field formation unit 23 in the plasma pretreatment step will be described. The magnetic field formation unit 23 forms a magnetic field between the pretreatment roller 20 and the electrode unit 21. The magnetic field can act to capture and accelerate electrons present between the pretreatment roller 20 and the electrode unit 21. Hence, in a region where the magnetic field is formed, the frequency of collision between electrons and the plasma raw material gas can be increased, the density of the plasma can be increased and the plasma can be localized, with the result that it is possible to enhance the efficiency of the plasma pretreatment.

(Film formation step)

In the film formation step, the film formation mechanism 11C is used, and thus the film is formed on the surface of the base material 1. As an example of the film formation step, a case where the film formation mechanism 11C including the evaporation mechanism 24 shown in FIG. 6 is used, and thus the aluminum oxide vapor-deposited film is formed will be described.

The vapor deposition material including aluminum is supplied into the boat 24b of the evaporation mechanism 24 such that the vapor deposition material is opposite the film formation roller 25. As the vapor deposition material, an aluminum metal wire can be used. In the example shown in FIG. 6, the vapor deposition material supply unit 61 continuously feeds the aluminum metal wire into the boat 24b, and thus the vapor deposition material is supplied into the boat 24b.

By heating, aluminum is evaporated in the boat 24b. In FIG. 6, for convenience, evaporated aluminum vapor 63 is shown. Although oxygen gas which oxidizes aluminum may be supplied as oxygen alone or as a mixed gas with an inert gas such as argon, the amount of oxygen is controlled, and thus it is possible to achieve both barrier properties and transparency. The pressure here is preferably equal to or greater than 0.05 Pa and equal to or less than 8.0 Pa.

A method for supplying the plasma to the area between the surface of the base material 1 and the evaporation mechanism 24 using the plasma supply mechanism 50, that is, the plasma assistance during the vapor deposition will be described. In the present embodiment, the plasma is generated inside the hollow portion of the hollow cathode 51 in the plasma supply mechanism 50. Then, discharge is generated between the hollow cathode 51 and the anode opposite the hollow cathode 51, and thus the plasma inside the hollow portion of the hollow cathode 51 is drawn to the area between the surface of the base material 1 and the evaporation mechanism 24.

In the present embodiment, the discharge generated between the hollow cathode 51 and the anode opposite the hollow cathode 51 is arc discharge. The arc discharge means, for example, discharge in which the value of current is equal to or greater than 10 A.

While the plasma is being supplied to the area between the surface of the base material 1 and the evaporation mechanism 24, aluminum is evaporated, and thus the plasma is supplied to the aluminum vapor 63. The plasma is supplied, and thus it is possible to facilitate the reaction or combination of the aluminum vapor 63 and oxygen gas. In this way, the aluminum vapor 63 can be oxidized before the aluminum vapor 63 reaches the surface of the base material 1. The evaporated and oxidized aluminum is adhered to the base material 1, and thus the aluminum oxide vapor-deposited film is formed on the surface of the base material 1, with the result that the barrier film shown in FIG. 1 can be manufactured.

The plasma raw material gas supplied by the plasma supply mechanism 50 is preferably argon gas.

In the present embodiment, before the film formation step, the plasma pretreatment step of supplying the plasma to the surface of the base material 1 is performed. In the plasma pretreatment step, the alternating-current voltage is applied to the area between the electrode unit 21 and the pretreatment roller 20. The magnetic field formation unit 23 located on the surface on a side opposite to the surface opposite the pretreatment roller 20 is utilized, and thus a magnetic field is generated in a space between the electrode unit 21 and the pretreatment roller 20. Hence, it is possible to efficiently generate the plasma in the space between the electrode unit 21 and the pretreatment roller 20, and to apply the plasma perpendicularly to the surface of the base material 1 wound around the pretreatment roller 20. Therefore, it is possible to enhance adhesion between the film formed in the film formation step and the base material 1.

(Aging treatment after film formation step)

The winding member of the barrier film which has undergone the film formation step is subjected to aging treatment (heating treatment) for a predetermined period of time. In this way, the introduction of hydroxyl groups into the aluminum oxide vapor-deposited film is facilitated, and thus the vapor-deposited film having excellent oxygen permeability and water vapor permeability is formed.

An aging temperature is preferably equal to or greater than 50°C and equal to or less than 60°C. The lower limit value of an aging time is equal to or greater than 24 hours (one day), and more preferably equal to or greater than 48 hours (two days). The upper limit value is equal to or less than 144 hours (six days), and more preferably equal to or less than 96 hours (four days). Although an aging humidity is not particularly limited, the aging humidity does not need to be high, and the aging humidity may be a normal relative humidity which is equal to or greater than 40% and equal to or less than 70%.

(Covering layer formation step)

A covering layer 3 can be manufactured by the following method. First, the metal alkoxide described above, a water-soluble polymer, a silane coupling agent which is added as necessary, a sol-gel catalyst, an acid, water serving as a solvent and an organic solvent such as an alcohol of methyl alcohol, ethyl alcohol or isopropanol are mixed, and thus a barrier coat agent is prepared. Then, the barrier coat agent is applied onto the aluminum oxide vapor-deposited film by a conventional method, and is dried. In the drying step described above, polycondensation of silanol generated from the metal alkoxide and the silane coupling agent is further facilitated, and a coating film is formed. The drying conditions are that heating treatment is performed for 3 seconds to 10 minutes at a temperature which is in a range of 20 to 200°C and is equal to or less than the melting point of the plastic base material, and preferably at a temperature in a range of 50 to 180°C. In this way, it is possible to form the covering layer 3 of the barrier coat agent on the aluminum oxide vapor-deposited film. On the first coating film, the application operation described above may be further repeated to form a plurality of coating films which are two or more layers.

The winding member for the barrier film which has undergone the covering layer formation step described above is subjected to aging treatment (heating treatment) for a predetermined period of time. In this way, the condensation of the covering layer is appropriately facilitated, and thus the barrier film in which barrier properties after a retort test are unlikely to be lowered is obtained.

The lower limit value of the aging temperature after the covering layer formation step is preferably equal to or greater than 40°C, and more preferably equal to or greater than 50°C. The upper limit value is preferably equal to or less than 100°C, and more preferably equal to or less than 70°C. The lower limit value of the aging time is equal to or greater than 24 hours (one day), and more preferably equal to or greater than 48 hours (two days). The upper limit value is equal to or less than 144 hours (six days), and more preferably equal to or less than 96 hours (four days). Although an aging humidity is not particularly limited, the aging humidity does not need to be high, and the aging humidity may be a normal relative humidity which is equal to or greater than 40% and equal to or less than 70%.

(Film formation step 2)

The aluminum oxide vapor-deposited film may be further formed on the covering layer. The film can be formed under the same conditions as in the film formation step and the aging treatment described above.

(Covering layer formation step 2)

The covering layer may be further formed on the aluminum oxide vapor-deposited film which has been vapor-deposited through the film formation step 2. The film can be formed under the same conditions as in the covering layer formation step described above.

(Multilayer member)

FIG. 7 is a cross-sectional view showing an example of the multilayer member which uses the barrier film according to the present invention. The multilayer member 100 described above is a multilayer member which uses the barrier film 100A in FIG. 1. In other words, the barrier film 100A is formed with the first polypropylene base material 110, the underlayer 115, the vapor-deposited film 120 and the covering layer 130 having barrier properties. One surface of the barrier film on the side of the first polypropylene base material 110 is stacked on a sealant layer 150 via a first adhesive layer 161, and the other surface of the barrier film on the side of the covering layer 130 is stacked on a second polypropylene base material 140 via an adhesive layer 162. In other words, the multilayer member has a three-layer film configuration of the second polypropylene base material 140, the second adhesive layer 162, the barrier film, the first adhesive layer 161 and the sealant layer 150 with the barrier film used as an intermediate layer. The configuration other than the barrier film A will be described below.

[Adhesive layer]

The surface of the barrier film on the side of the first polypropylene base material 110 is stacked on the sealant layer 150 via the first adhesive layer 161, and the surface of the barrier film on the side of the covering layer 130 is stacked on the second polypropylene base material 140 via the adhesive layer 162. In this way, it is possible to enhance adhesion between the barrier film and the sealant layer and adhesion between the first polypropylene base material and the second base material, and thus it is possible to suppress a decrease in barrier properties caused by the heat sterilization treatment such as the retort treatment or the boiling treatment.

Each of the first adhesive layer 161 and the second adhesive layer 162 may be formed of one of a one-component curing adhesive, a two-component curing adhesive and a noncuring adhesive. The adhesive may be a solvent-free adhesive or a solvent-based adhesive suitable for dry lamination.

Examples of the solvent-free adhesive, that is, a nonsolvent stacking adhesive include a polyether adhesive, a polyester adhesive, a silicone adhesive, an epoxy adhesive and a urethane adhesive. Among them, a urethane adhesive is preferable, and a two-component curing urethane adhesive is more preferable.

Examples of the solvent-based adhesive include a rubber adhesive, a vinyl adhesive, an olefin adhesive, a silicone adhesive, an epoxy adhesive, a phenolic adhesive and a urethane adhesive. Among them, a urethane adhesive is preferable, and a two-component curing urethane adhesive is more preferable.

The thickness of the adhesive layer is, for example, equal to or greater than 0.1 $\mu$m and equal to or less than 10 $\mu$m, preferably equal to or greater than 0.2 $\mu$m and equal to or less than 8 $\mu$m and further preferably equal to or greater than 0.5 $\mu$m and equal to or less than 6 $\mu$m.

[Second polypropylene base material]

The second polypropylene base material 140 is stacked on the surface of the barrier film on the side of the covering layer 30 via the second adhesive layer 162. Here, since as the second polypropylene base material, the same one as the first polypropylene base material 110 can be used, the description thereof is omitted.

In the case of the three-layer configuration as shown in FIG. 7, a printing layer (not shown) may be formed on the outermost layer of the second polypropylene base material 140, or may be formed on the surface of the second polypropylene base material 140 on the side of the second adhesive layer 162.

[Sealant layer]

The sealant layer 150 contains a resin material which can be fused together by heat. Examples of the resin material which can be fused together by heat include polyolefin, and specific examples thereof include polyethylenes such as a low density polyethylene, a linear low density polyethylene and a medium density polyethylene, polypropylene, polybutene, a methylpentene polymer and a cyclic olefin copolymer.

The sealant layer is preferably formed of the polypropylene. In this way, all films in the three-layer configuration are formed of the polypropylene, and thus a packaging material can be formed of a mono-material. After a used packaging material is collected, it is not necessary to separate the base material and the sealant layer, and thus it is possible to enhance the recyclability of the packaging material. The sealant layer is formed of the polypropylene, and thus oil resistance can be enhanced, and the sealant layer can withstand the heat sterilization treatment.

The content of the polypropylene in the sealant layer is preferably equal to or greater than 70% by mass, more preferably equal to or greater than 80% by mass, further preferably equal to or greater than 90% by mass and still further preferably equal to or greater than 95% by mass. In this way, for example, it is possible to enhance the recyclability of the packaging material.

When the sealant layer is formed of the polypropylene, the content of the polypropylene in the total amount of the resin material included in the multilayer member is preferably equal to or greater than 80% by mass, more preferably equal to or greater than 85% by mass, further preferably equal to or greater than 88% by mass and particularly preferably equal to or greater than 90% by mass. In this way, for example, a mono-material packaging material can be produced using the multilayer member, and thus it is possible to enhance the recyclability of the packaging material.

Examples of the polypropylene include a propylene homopolymer, a propylene random copolymer such as a propylene-$\alpha$-olefin random copolymer and a propylene block copolymer such as a propylene-$\alpha$-olefin block copolymer. The details of the $\alpha$-olefin have been described above. In terms of heat sealing properties, the density of the polypropylene is, for example, equal to or greater than 0.88 g/cm$^3$ and equal to or less than 0.92 g/cm$^3$. The density is measured in accordance with JIS K7112, and in particular, Method D (density gradient tube method, 23°C). In terms of reducing an environmental load, a biomass-derived polypropylene and/or a recycled polypropylene may be used.

The sealant layer may contain an additive. Examples of the additive include a crosslinking agent, an antioxidant, an antiblocking agent, a slip agent, an ultraviolet absorber, a light stabilizer, a filler, a reinforcing agent, a lubricant, an antistatic agent, a pigment and a modifying resin. For example, the sealant layer may contain an antistatic agent. In this way, it is possible to suppress the generation of static electricity on the surface of the multilayer member, and to suppress, for example, adhesion between the multilayer members.

The sealant layer may have a single layer structure or a multilayer structure. The thickness of the sealant layer is preferably equal to or greater than 10 $\mu$m and equal to or less than 200 $\mu$m, and more preferably equal to or greater than 20 $\mu$m and equal to or less than 150 $\mu$m. When the thickness is equal to or greater than the lower limit value thereof, for example, the stacking strength of the packaging material included in the multilayer member can be more enhanced. When the thickness is equal to or less than the upper limit value thereof, for example, the processability of the multilayer member can be more enhanced. When a pouch (in particular, a retort pouch) is produced from the multilayer member, the thickness of the sealant layer is further preferably equal to or greater than 30 μm and equal to or less than 100 μm.

In terms of heat sealing properties, the sealant layer is preferably an unstretched resin film, and more preferably an unstretched polypropylene film. The resin film can be produced by utilizing, for example, a casting method, a T-die method, an inflation method or the like. The sealant layer may be stacked via the adhesive layer as in the present embodiment, or may be formed by melt-extruding a resin material capable of being fused together by heat onto the barrier film.

[Another stacking example]

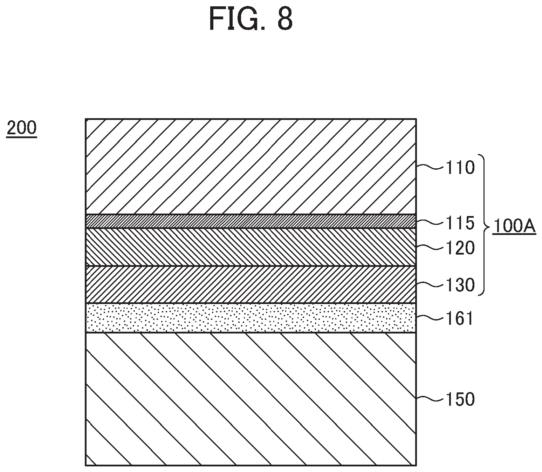

FIG. 8 shows an example where the covering layer 130 of the barrier film A is stacked on the sealant layer 150 via the first adhesive layer 161. As described above, in the present invention, the multilayer member may have a two-layer configuration instead of the three-layer film configuration.

[Packaging product]

The multilayer member can be utilized as a packaging product such as a packaging bag which is formed into a bag shape with the sealant layer on the inside to contain contents such as food. The multilayer member in the present invention is used for a packaging bag which contains retort pouch food or boiled food, and has been subjected to the heat sterilization treatment.

The heat sterilization treatment includes not only the retort treatment but also the boiling treatment. The boiling treatment means, for example, heat sterilization at 60 to 100°C for 10 to 60 minutes.

The retort treatment means heat and pressure sterilization treatment at 100 to 140°C. The heat and pressure sterilization treatment where an F value which is a concept representing the integral value of a load heat amount is equal to or greater than 4, and more specifically, the treatment is performed at 121°C for 3 or more minutes, or is performed at 120°C for 4 or more minutes defined in the food sanitation law is preferable. More specifically, the heat and pressure sterilization treatment is most generally performed at 120°C for 30 to 60 minutes, and may be performed under semi-retort conditions of 105 to 115°C and 30 to 60 minutes or under highretort (HTST) conditions of 130 to 140°C and 30 to 60 minutes.

[Composite elastic modulus and indentation hardness of covering layer]

In the present invention, a composite elastic modulus and an indentation hardness after the stacking and the heat sterilization treatment are measured from a cross section of the covering layer of the multilayer member by a nanoindentation method, the composite elastic modulus is equal to or greater than 5.0 GPa and equal to or less than 8.5 GPa, and the indentation hardness is equal to or greater than 0.9 GPa and equal to or less than 1.7 GPa. In these ranges, it is possible to suppress a decrease in the barrier properties even after not only the boiling treatment on the multilayer member but also the retort treatment thereon.

Further preferably, the composite elastic modulus is equal to or greater than 6.0 GPa and equal to or less than 8.5 GPa, and the indentation hardness is equal to or greater than 1.0 GPa and equal to or less than 1.5 GPa, with the result that it is possible to suppress a decrease in the barrier properties even after high retort treatment on the multilayer member.

The indentation hardness of the covering layer is calculated by equation (1) below. Furthermore, the composite elastic modulus of the covering layer is calculated by equation (2) below.

$$\text{indentation hardness} = P_{max}/A \quad \cdots (1)$$

[Math. 1]

$$\text{Composite elastic modulus} = \frac{S\sqrt{\pi}}{2\sqrt{A}} \quad \cdots (2)$$

Here,

Pmax: maximum load (unit: μN)
A: contact projection area at maximum depth (unit: μm²)
S: contact rigidity

In the measurements of the composite elastic modulus and the indentation hardness of the covering layer in the multilayer member after the heat sterilization treatment, pretreatment is performed by embedding the multilayer member after the heat sterilization treatment in an epoxy resin or the like, and treating it with a microtome to expose the cross section of the covering layer. In this way, the composite elastic modulus and the indentation hardness can be measured by the nanoindentation method from the "cross section" of the covering layer of the multilayer member. By this method, it is possible to measure the composite elastic modulus and the indentation hardness of the covering layer without peeling off the multilayer member to expose the covering layer. The cross section is obtained by cutting the film in the direction of thickness perpendicular to the main surface of the film. The cross section was prepared by embedding the film in an embedding resin to produce a block, and cutting the block using a commercially available rotary microtome at room temperature (23°C). The finishing was performed with a diamond knife.

In the measurements of the indentation hardness and the composite elastic modulus of the cross section of the covering layer performed by the nanoindentation method, an indenter is first placed on the cross section of the covering layer, the indenter is pressed from the cross section to a load of 15 μN over 10 seconds and the indenter is held in that state for 5 seconds. The indenter is pressed into the vicinity of a center portion in the direction of thickness of the covering layer in the exposed cross section of the covering layer. The load is then released over a period of 10 seconds. In this way, it is possible to obtain the maximum load Pmax, the contact projection area A at the maximum depth and a load-displacement curve. Unless otherwise specified, the measurements are performed at a relative humidity of 50% and at a temperature of 23°C. The measurements are performed at five or more parts on the same cross section, and each of the indentation hardness and the composite elastic modulus is recorded as the arithmetic mean value of the values measured at the five parts with good reproducibility. Further detailed conditions for the measurements are described in Examples.

When the multilayer member is subjected to the heat sterilization treatment, the covering layer needs to have a certain degree of hardness to suppress destruction of the vapor-deposited film caused by thermal shrinkage of the OPP base material during the heat sterilization treatment. On the other hand, although during the stacking of the packaging material, the OPP base material is stretched by tension, and thus the barrier properties are also lowered by the destruction of the vapor-deposited film, it is possible to suppress a decrease in the barrier properties by providing appropriate flexibility to the covering layer.

The present inventors have found the ranges of the elastic modulus and the indentation hardness suitable for the heat sterilization treatment such as the retort treatment in the covering layer of the mono-material packaging material which is the multilayer member of a polypropylene film, and thereby have found the multilayer member in which a decrease in the barrier properties can be suppressed even after the "stacking" and the "heat sterilization treatment".

In this way, the oxygen permeability of the multilayer member after the heat sterilization treatment at 23°C and at 90% RH in accordance with JIS K 7126-2 has been successfully achieved to be equal to or less than 10.0 cc/(m²·day·atm), preferably equal to or less than 5.0 cc/(m²·day·atm), particularly preferably equal to or less than 2.0 cc/(m²·day·atm) and most preferably equal to or less than 1.0 cc/(m²·day·atm). Moreover, the water vapor permeability at 40°C and at 100% RH after the heat sterilization treatment in accordance with B method, JIS K 7129 is preferably less than 2.0 g/(m²·day), more preferably equal to or less than 1.5 g/(m²·day) and particularly preferably equal to or less than 1.0 g/(m²·day). Consequently, the multilayer member having high gas barrier properties even after the retort treatment is obtained.

The composite elastic modulus and the indentation hardness of the covering layer can be adjusted, for example, by the composition of the covering layer, a drying temperature during the formation of the covering layer or the like.

EXAMPLES

Although the present invention will be described in further detail below using Examples, the present invention is not limited to Examples at all. Barrier films according to Examples 1 to 13 and Comparative Examples 1 to 10 were first manufactured using the film formation device 10, that is, the film formation device according to the present embodiment, the film formation method and the covering layer formation step. Pretreatment conditions, vapor deposition conditions and the like are collectively shown in Tables 1 and 2.

(Example 1)

As the polypropylene base material of a base material 1, a biaxially stretched polypropylene film having a thickness of 20 μm (a first layer serving as a surface on the side of a vapor-deposited surface had a thickness of 1.0 μm and was formed of a copolymer of propylene, ethylene and butene, a second layer serving as a surface on a side opposite to the side of the vapor-deposited surface had a thickness of 1.0 μm and was formed of a copolymer of propylene, ethylene and butene, corona treatment was subjected to the surface of the first layer and a third layer (intermediate layer) had a thickness of 18 μm and was formed of homopolypropylene) was used.

Then, a coating liquid for forming an anchor coat layer which was a mixture of a hydroxyl group-containing (meth) acrylic resin and tolylene diisocyanate was applied onto the first layer of the base material 1 by a direct gravure method as an underlayer, and was then dried to form an anchor coat layer having a thickness of 0.2 μm.

After the formation of the anchor coat layer, a roll of original fabric was rewound in an atmosphere of 25°C and 50% RH as a humidity-conditioning step, and was then stored at 25°C and 50% RH for 3 days, with the result that the humidity was conditioned.

In the film formation step, a vapor-deposited film including an aluminum oxide was formed by a vacuum vapor deposition method using the evaporation mechanism 24 of a resistance heating type (represented by RH in Table 1) as shown in FIG. 6. Specifically, while an aluminum metal wire was being supplied into a boat 24b as a vapor deposition material, the evaporation mechanism 24 of the resistance heating type was used to heat the vapor deposition material in the boat 24b, aluminum was evaporated so as to reach the surface of the base material 1 and the vapor-deposited film was formed on the surface of the base material 1 while oxygen was being supplied.

A plasma supply mechanism 50 including a hollow cathode 51 shown in FIG. 6 and unillustrated anodes which were arranged on both sides of the base material 1 in the width direction when viewed from the boat 24b and were opposite the opening of the hollow portion of the hollow cathode 51 was used, a plasma raw material gas (argon gas) was supplied into the hollow portion of the hollow cathode 51, thus discharge was generated to excite plasma, the plasma was drawn by the opposite anodes to an area between the surface of the base material 1 and the evaporation mechanism 24 and thereby plasma assistance during vapor deposition was performed. The conditions of the plasma assistance were set such that the amount of argon supplied to the hollow cathode was 80 sccm, an anode current was 154 A and an anode voltage was 18 V. A plasma post-treatment step after the plasma assistance step during vapor deposition was not performed.

By the method described above, the vapor-deposited film was stacked on the base material 1. Here, a conveyance speed was 600 m/min, and the thickness of the vapor-deposited film was 8.9 nm. Here, a light transmittance with a wavelength of 366 nm measured in-line after vapor deposition was set relative to the transmittance of 100% when the base material 1 was pretreated and was not vapor-deposited. Then, vapor deposition was started, and an oxygen supply amount was feedback-controlled such that the light transmittance was 99.7%. The pressure during vapor deposition was 1.1 Pa.

A winding member for the barrier film which had undergone the film formation step described above was subjected to aging treatment at 55°C and at 50% RH for three days.

Furthermore, in the covering layer formation step, the covering layer was stacked on the vapor-deposited film. Polyvinyl alcohol serving as a water-soluble polymer and having a degree of saponification of 99% or more and a degree of polymerization of 2400 was mixed with a liquid of water and isopropyl alcohol in a ratio of 95/5, and thus a solution A which was adjusted to have a solid content of 4% was obtained. Water, isopropyl alcohol and 1N hydrochloric acid were mixed and adjusted in a ratio of 65/34/1, and thus a solution B was obtained. Tetraethoxysilane was used as a metal alkoxide, and was prepared as a solution C. A liquid obtained by adjusting the ratio between the solution B and the solution C and mixing the solution B and the solution C was used as a solution D, and a liquid obtained by adjusting the ratio between the solution A and the solution D and mixing the solution A and the solution D was used as a barrier coat agent. The ratio between the solution B and the solution C and the ratio between the solution A and the solution D were adjusted such that the solid content of the barrier coat agent after mixing was 7% and the mass of tetraethoxysilane in terms of $SiO_2$ was 2.5 relative to the solid content of PVA. The barrier coat agent was used as a solution X.

The barrier coat agent prepared as described above was applied onto the vapor-deposited film using an applicator. Thereafter, drying was performed at 100°C, and thus a covering layer having a dried film thickness of 300 nm was formed. Thereafter, aging treatment was performed at 55°C and at 50% RH for seven days, and thus the barrier film in Example 1 was manufactured.

(Example 2)

The barrier film in Example 2 was manufactured as in Example 1 except that the conditions of the plasma assistance were set such that the anode current was 140 A and the anode voltage was 16 V.

(Example 3)

The barrier film in Example 3 was manufactured as in Example 2 except that the aging treatment after the film formation step was performed at 60°C and at 50% RH for four days.

(Example 4)

The barrier film in Example 4 was manufactured as in Example 1 except that, in the covering layer formation step, the ratio between the solution B and the solution C and the ratio between the solution A and the solution D were adjusted such that the mass of tetraethoxysilane in terms of $SiO_2$ was 2.25 relative to the solid content of PVA.

(Example 5)

The barrier film in Example 5 was manufactured as in Example 1 except that, in the covering layer formation step, the ratio between the solution B and the solution C and the ratio between the solution A and the solution D were adjusted such that the mass of tetraethoxysilane in terms of $SiO_2$ was 2.75 relative to the solid content of PVA.

(Example 6)

The barrier film in Example 6 was manufactured as in Example 1 except that, in the covering layer formation step, the ratio between the solution B and the solution C and the ratio between the solution A and the solution D were adjusted such that the mass of tetraethoxysilane in terms of $SiO_2$ was 3.0 relative to the solid content of PVA.

(Example 7)

The barrier film in Example 7 was manufactured as in Example 1 except that, in the covering layer formation step, the ratio between the solution B and the solution C and the ratio between the solution A and the solution D were adjusted such that the mass of tetraethoxysilane in terms of $SiO_2$ was 3.5 relative to the solid content of PVA.

(Example 8)

The barrier film in Example 8 was manufactured as in Example 1 except that, in the covering layer formation step, a solution Y was used. When the solution B and the solution C were mixed, 5% of glycidoxypropyltrimethoxysilane was added relative to the weight of tetraethoxysilane, thereafter, the ratio between the solution B and the solution C and the ratio between the solution A and the solution D were adjusted such that the solid content of the covering layer was 7% and the mass of tetraethoxysilane in terms of $SiO_2$ was 2.5 relative to the solid content of PVA and a barrier coat agent obtained by mixing was used as the solution Y.

(Example 9)

The barrier film in Example 9 was manufactured as in Example 8 except that, in the covering layer formation step, the ratio between the solution B and the solution C and the ratio between the solution A and the solution D were adjusted such that the mass of tetraethoxysilane in terms of $SiO_2$ was 3.5 relative to the solid content of PVA.

(Example 10)

The barrier film in Example 10 was manufactured as in Example 1 except that, in the covering layer formation step, a solution Z was used. When the solution B and the solution C were mixed, 8% of 1,3,5-tris(3-trialkoxysilylpropyl) isocyanurate was added relative to the weight of tetraethoxysilane, the ratio between the solution B and the solution C and the ratio between the solution A and the solution D were adjusted such that the solid content of the covering layer was 7% and the mass of tetraethoxysilane in terms of $SiO_2$ was 3.5 relative to the solid content of PVA and a barrier coat agent obtained by mixing was used as the solution Z.

(Example 11)

The barrier film in Example 11 was manufactured as in Example 1 except that the aging treatment after the formation of the covering layer was not performed.

(Example 12)

The barrier film in Example 12 was manufactured as in Example 7 except that the aging treatment after the formation of the covering layer was not performed.

(Example 13)

A base material (total thickness of 20 μm) was obtained by using a polyamide resin as the underlayer, using a modified polypropylene as the first layer, using homopolypropylene as the third layer, using a layer formed of a copolymer of propylene and ethylene as the second layer and stretching after coextrusion of a multilayer of the underlayer, the first layer, the third layer and the second layer, and the resulting base material was used as the base material 1. The thickness of the underlayer was set to about 0.6 $\mu$m, the thickness of the first layer was set to about 1.5 $\mu$m and the thickness of the second layer was set to about 0.6 $\mu$m. As the polyamide resin, nylon 6 was used.

Thereafter, as the humidity-conditioning step, a roll of original fabric was rewound in an atmosphere of 25°C and 50% RH, and was then stored at 25°C and at 50% RH for 3 days, and thus the humidity-conditioned roll of original fabric was used.

The gas barrier film in Example 13 was manufactured by performing the film formation step and the covering layer formation step as in Example 1 except that, in the film formation step in Example 1, the following pretreatment step was performed.

<Pretreatment step>

The plasma pretreatment mechanism 11B shown in FIGS. 2 and 3 was used, and thus the plasma pretreatment was performed on the surface of the base material 1. Specifically, first, while a plasma raw material gas supply unit was being used to supply a plasma formation gas into a plasma pretreatment chamber 12B, a decompression chamber 12 was used to adjust a pressure in the plasma pretreatment chamber 12B. Then, a voltage was applied to an area between a pretreatment roller 20 and an electrode unit 21 to generate plasma, and thus the plasma pretreatment was performed on the surface of the base material 1. The conditions of the plasma pretreatment were set as follows.

<Pretreatment conditions>

Conveyance speed of base material: 600 m/min
High frequency power supply output: 4 kW
High frequency power supply frequency: 40 kHz
Plasma intensity: 550 W · sec/m$^2$
Plasma formation gas: oxygen 100 (sccm), argon 1000 (sccm) Magnetic formation means: 1000 gauss permanent magnet Voltage applied between pretreatment drum and plasma supply nozzle: 420 V
Pressure in pretreatment compartment: $2.0 \times 10^{-1}$ Pa

(Example 14)

A base material film including the underlayer (0.7 $\mu$m), the first layer (1.5 $\mu$m), the third layer (17.1 $\mu$m) and the second layer (0.7 $\mu$m) and having a thickness of 20 $\mu$m was produced by using, as the underlayer, a mixture (referred to as PA mixture in Table 1) of 50% by mass of a copolymer of metaxylenediamine and adipic acid and 50% by mass of a copolymer of a dicarboxylic acid having a molar ratio of an isophthalic acid to terephthalic acid of 2/1 and hexamethylenediamine, using an acid-modified polypropylene random copolymer as the first layer, using homopolypropylene as the third layer, using a layer formed of a copolymer of propylene, ethylene and butene as the second layer, coextruding the underlayer, the first layer, the third layer and the second layer and then using a sequential biaxial stretching device to stretch the resulting multilayer five times in a longitudinal direction (MD direction) and ten times in a lateral direction (TD direction).

Thereafter, as the humidity-conditioning step, a roll of original fabric was rewound in an atmosphere of 25°C and 50% RH, and was then stored at 25°C and at 50% RH for 3 days, and thus the humidity-conditioned roll of original fabric was used.

The film formation step was performed as in Example 1 except that, in the film formation step in Example 3, the aging treatment after the film formation step was performed at 55°C and at 50% RH for seven days.

The subsequent covering layer formation step was not performed, and the gas barrier film in Example 14 was manufactured.

(Example 15)

After the film formation step for the gas barrier film in Example 14, as the covering layer, a covering layer having a thickness of 200 nm was formed by applying a coating liquid for forming a covering layer (referred to as PU in table 2) which was a mixture of a polyurethane emulsion and an emulsion of an oxazoline group-containing polymer by the direct gravure method, and then drying the coating liquid. Thereafter, the aging treatment was performed at 55°C and at 50% RH for seven days, and thus the barrier film in Example 15 was manufactured.

(Comparative Example 1)

The barrier film in Comparative Example 1 was manufactured as in Example 1 except that, in the film formation step, the conditions of the plasma assistance were set such that the anode current was 176 A and the anode voltage was 18 V.

(Comparative Example 2)

The barrier film in Comparative Example 2 was manufactured as in Example 1 except that the aging treatment after the film formation step was not performed.

(Comparative Example 3)

The barrier film in Comparative Example 3 was manufactured as in Example 1 except that, in the film formation step, the conditions of the plasma assistance were set such that the anode current was 48 A and the anode voltage was 19 V.

(Comparative Example 4)

The barrier film in Comparative Example 4 was manufactured as in Example 1 except that, in the film formation step, the plasma assistance was not performed.

(Comparative Example 5)

The barrier film in Comparative Example 5 was manufactured as in Example 1 except that, in the film formation step, the conveyance speed was set to 670 m/min, the thickness of the vapor-deposited film was set to 8.0 nm, the light transmittance was set to 94.0% and the pressure was set to 0.3 Pa, and the plasma assistance was not performed.

(Comparative Example 6)

The barrier film in Comparative Example 6 was manufactured as in Example 1 except that, in the film formation step, the light transmittance was set to 88.0%, and the pressure was set to 0.2 Pa.

(Comparative Example 7)

The barrier film in Comparative Example 7 was manufactured as in Example 1 except that, in the covering layer formation step, the ratio between the solution B and the solution C and the ratio between the solution A and the solution D were adjusted such that the mass of tetraethoxysilane in terms of $SiO_2$ was 1.5 relative to the solid content of PVA.

(Comparative Example 8)

The barrier film in Comparative Example 8 was manufactured as in Example 1 except that, in the covering layer formation step, the ratio between the solution B and the solution C and the ratio between the solution A and the solution D were adjusted such that the mass of tetraethoxysilane in terms of $SiO_2$ was 4.0 relative to the solid content of PVA.

(Comparative Example 9)

The barrier film in Comparative Example 9 was manufactured as in Example 10 except that, in the covering layer formation step, the ratio between the solution B and the solution C and the ratio between the solution A and the solution D were adjusted such that the mass of tetraethoxysilane in terms of $SiO_2$ was 4.0 relative to the solid content of PVA in the solution Z.

(Comparative Example 10)

The barrier film in Comparative Example 10 was manufactured as in Comparative Example 5 except that as the base material 1, a base material including the underlayer in Example 13 was used, and in the film formation step, the same pretreatment step as in Example 13 was performed.

[Table 1]

| | Underlayer | Conveyance speed (m/min) | Vapor deposition method | Plasma assistance conditions | | | Permeability (%) @366nm | Pressure (Pa) | Aging after vapor deposition |
| --- | --- | --- | --- | --- | --- | --- | --- | --- | --- |
| | | | | Hollow cathode Ar flow rate (sccm) | Anode Current (A) | Anode Voltage (V) | | | |
| Example 1 | AC | 600 | RH | 80 | 154 | 18 | 99.7 | 1.1 | 55°C, 50% RH for three days |
| Example 2 | AC | 600 | RH | 80 | 140 | 16 | 99.7 | 1.1 | 55°C, 50% RH for three days |
| Example 3 | AC | 600 | RH | 80 | 140 | 16 | 99.7 | 1.1 | 60°C, 50% RH for four days |
| Example 4 | AC | 600 | RH | 80 | 154 | 18 | 99.7 | 1.1 | 55°C, 50% RH for three days |
| Example 5 | AC | 600 | RH | 80 | 154 | 18 | 99.7 | 1.1 | 55°C, 50% RH for three days |
| Example 6 | AC | 600 | RH | 80 | 154 | 18 | 99.7 | 1.1 | 55°C, 50% RH for three days |
| Example 7 | AC | 600 | RH | 80 | 154 | 18 | 99.7 | 1.1 | 55°C, 50% RH for three days |
| Example 8 | AC | 600 | RH | 80 | 154 | 18 | 99.7 | 1.1 | 55°C, 50% RH for three days |
| Example 9 | AC | 600 | RH | 80 | 154 | 18 | 99.7 | 1.1 | 55°C, 50% RH for three days |
| Example 10 | AC | 600 | RH | 80 | 154 | 18 | 99.7 | 1.1 | 55°C, 50% RH for three days |
| Example 11 | AC | 600 | RH | 80 | 154 | 18 | 99.7 | 1.1 | 55°C, 50% RH for three days |
| Example 12 | AC | 600 | RH | 80 | 154 | 18 | 99.7 | 1.1 | 55°C, 50% RH for three days |
| Example 13 | Ny | 600 | RH | 80 | 154 | 18 | 99.7 | 1.1 | 55°C, 50% RH for three days |

| | Underlayer | Conveyance speed (m/min) | Vapor deposition method | Plasma assistance conditions | | | Permeability (%) @366nm | Pressure (Pa) | Aging after vapor deposition |
|---|---|---|---|---|---|---|---|---|---|
| | | | | Hollow cathode Ar flow rate (sccm) | Anode Current (A) | Anode Voltage (V) | | | |
| Example 14 | PA mixture | 600 | RH | 80 | 154 | 18 | 99.7 | 1.1 | 55°C, 50% RH for seven days |
| Example 15 | PA mixture | 600 | RH | 80 | 154 | 18 | 99.7 | 1.1 | 55°C, 50% RH for three days |
| Comparative Example 1 | AC | 600 | RH | 80 | 176 | 18 | 99.7 | 1.1 | 55°C, 50% RH for three days |
| Comparative Example 2 | AC | 600 | RH | 80 | 154 | 18 | 99.7 | 1.1 | None |
| Comparative Example 3 | AC | 600 | RH | 80 | 48 | 19 | 99.7 | 1.1 | 55°C, 50% RH for three days |
| Comparative Example 4 | AC | 600 | RH | 0 | 0 | 0 | 99.7 | 1.1 | 55°C, 50% RH for three days |
| Comparative Example 5 | AC | 670 | RH | 0 | 0 | 0 | 94.0 | 0.3 | 55°C, 50% RH for three days |
| Comparative Example 6 | AC | 670 | RH | 0 | 0 | 0 | 88.0 | 0.2 | 55°C, 50% RH for three days |
| Comparative Example 7 | AC | 600 | RH | 80 | 154 | 18 | 99.7 | 1.1 | 55°C, 50% RH for three days |
| Comparative Example 8 | AC | 600 | RH | 80 | 154 | 18 | 99.7 | 1.1 | 55°C, 50% RH for three days |
| Comparative Example 9 | AC | 600 | RH | 80 | 154 | 18 | 99.7 | 1.1 | 55°C, 50% RH for three days |
| Comparative Example 10 | Ny | 670 | RH | 0 | 0 | 0 | 94.0 | 0.3 | 55°C, 50% RH for three days |

[Table 2]

| | Coating layer liquid composition | Aging after coating layer | AlOx vapor-deposited film | Coating layer |
|---|---|---|---|---|
| | | | Film thickness (nm) | Film thickness (nm) |
| Example 1 | Solution X | 55°C, 50% RH for seven days | 8.9 | 300 |
| Example 2 | Solution X | 55°C, 50% RH for seven days | 8.9 | 300 |
| Example 3 | Solution X | 55°C, 50% RH for seven days | 8.9 | 300 |
| Example 4 | Solution X | 55°C, 50% RH for seven days | 8.9 | 300 |
| Example 5 | Solution X | 55°C, 50% RH for seven days | 8.9 | 300 |
| Example 6 | Solution X | 55°C, 50% RH for seven days | 8.9 | 300 |
| Example 7 | Solution X | 55°C, 50% RH for seven days | 8.9 | 300 |
| Example 8 | Solution Y | 55°C, 50% RH for seven days | 8.9 | 300 |
| Example 9 | Solution Y | 55°C, 50% RH for seven days | 8.9 | 300 |
| Example 10 | Solution Z | 55°C, 50% RH for seven days | 8.9 | 300 |
| Example 11 | Solution X | None | 8.9 | 300 |
| Example 12 | Solution X | None | 8.9 | 300 |
| Example 13 | Solution X | 55°C, 50% RH for seven days | 8.9 | 300 |
| Example 14 | None | None | 8.9 | None |
| Example 15 | PU | 55°C, 50% RH for seven days | 8.9 | 200 |
| Comparative Example 1 | Solution X | 55°C, 50% RH for seven days | 8.9 | 300 |
| Comparative Example 2 | Solution X | 55°C, 50% RH for seven days | 8.9 | 300 |
| Comparative Example 3 | Solution X | 55°C, 50% RH for seven days | 8.9 | 300 |
| Comparative Example 4 | Solution X | 55°C, 50% RH for seven days | 8.9 | 300 |
| Comparative Example 5 | Solution X | 55°C, 50% RH for seven days | 8.0 | 300 |
| Comparative Example 6 | Solution X | 55°C, 50% RH for seven days | 8.0 | 300 |
| Comparative Example 7 | Solution X | 55°C, 50% RH for seven days | 8.9 | 300 |
| Comparative Example 8 | Solution X | 55°C, 50% RH for seven days | 8.9 | 300 |
| Comparative Example 9 | Solution Z | 55°C, 50% RH for seven days | 8.9 | 300 |
| Comparative Example 10 | Solution X | 55°C, 50% RH for seven days | 8.0 | 300 |

[Acquisition and analysis of XAFS spectrum]

For the barrier films in Examples 1 to 4 and Comparative Examples 1 to 10, XAFS spectra were obtained from the side of the surfaces of the barrier films (the surface side of the vapor-deposited film and the surface side of the covering layer) under the following measurement conditions. Among the results obtained, the result for Example 1 is shown in FIG. 9. A vertical axis in the figure represents the intensity of a fluorescent X-ray generated (shown as an absorption intensity (a. u) in the figure), and a horizontal axis represents light (or X-ray) energy (eV).

<Acquisition of XAFS spectrum>

· Utilized line: BL1N2 in Aichi Synchrotron Radiation Center
· Acceleration energy: 1.2 GeV
·Beam size: horizontal 1.0 mm × vertical 1.0 mm

·Incident angle to sample: 22.5° (direction perpendicular to the sample is assumed to be 0°)
·Entrance slit: 30 μm
·Exit slit: 30 μm
· Measurement method: partial fluorescence yield method Energy range (Al K-edge): 1500 to 1700 eV

Energy steps:

1500 to 1550 eV: 2.0 eV/step
1550 to 1555 eV: 1.0 eV/step
1555 to 1575 eV: 0.2 eV/step
1575 to 1600 eV: 0.5 eV/step
1600 to 1680 eV: 1.0 eV/step
1680 to 1700 eV: 2.0 eV/step
(Storage time: all 10 seconds/point)
· Energy calibration: energy calibration using Au 4f 7/2 of an AU plate (calibrated using a value obtained by subtracting a theoretical value of 1500 eV from an actually measured value)

<Analysis of XAFS spectrum>

Peak separation method

Intensity values were normalized such that the intensity value of an absorption spectrum at an absorbed X-ray energy value of 1557 eV was 0, and the intensity value of the absorption spectrum at an absorbed X-ray energy value of 1590 eV was 1.

[Math. 2]

$$f(x) = \sum_{i=1}^{3} \frac{h_i}{\{1 + M_i(x-X_i)^2/\beta_i^2\}\exp\{(1-M_i)[(ln2)(x-X_i)^2]/\beta_i^2\}}$$

$$+ \sum_{j=1}^{2} \frac{k_j}{\pi}\left(\tan^{-1}(x - K_j) + \frac{\pi}{2}\right)$$

The normalized data points from 1555 eV to 1575 eV and from 1598 eV to 1602 eV were extracted, and the function f(x) described above was fitted to determine each coefficient. However, constraints $k_1 = k_2$, $K_1 = X_1$ and $K_2 = X_2$ were included. The fitting was performed using a least squares method. In this case, a least squares function in Python's scipy library was used to determine the initial values of the coefficients by giving values shown in a table below. The definitions of symbols for the function are as follows. $M_i$: weighting factor of the Gaussian function and the Lorentzian function at the i-th absorption peak

$X_i$: peak center at the i-th absorption peak
$h_i$: peak intensity factor at the i-th absorption peak
$\beta_i$: peak width factor at the i-th absorption peak
$k_j$: baseline intensity factor at the j-th baseline
$K_j$: half-division position of a baseline intensity at the j-th baseline

[Table 3]

| $h_1$ | 4 |
|---|---|

(continued)

| | |
|---|---|
| $\beta_1$ | 0.8 |
| $M_1$ | 0.8 |
| $X_1$ | 1566 |
| $k_1$ | 1 |
| $K_1$ | 1566 |
| $h_2$ | 4 |
| $\beta_2$ | 0.8 |
| $M_2$ | 0.8 |
| $X_2$ | 1568 |
| $k_2$ | 1 |
| $K_2$ | 1568 |
| $h_3$ | 4 |
| $\beta_3$ | 0.8 |
| $M_3$ | 0.8 |
| $X_3$ | 1570 |

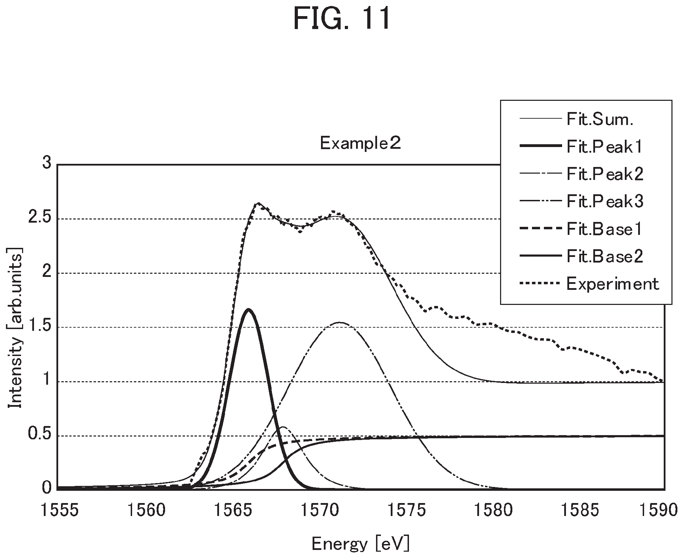

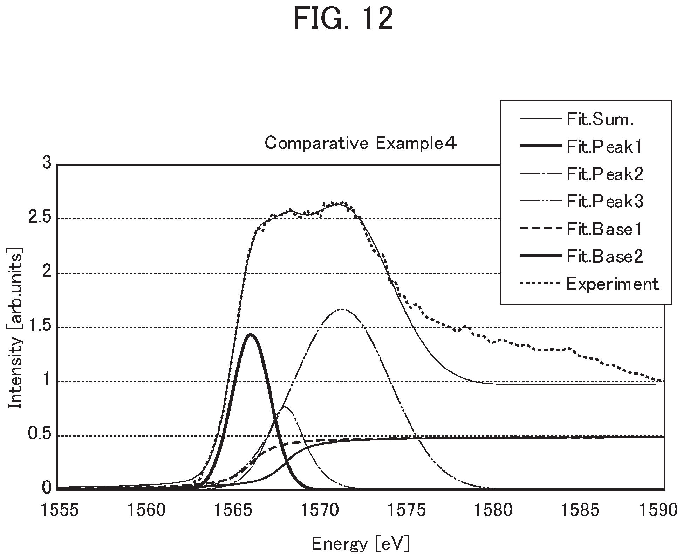

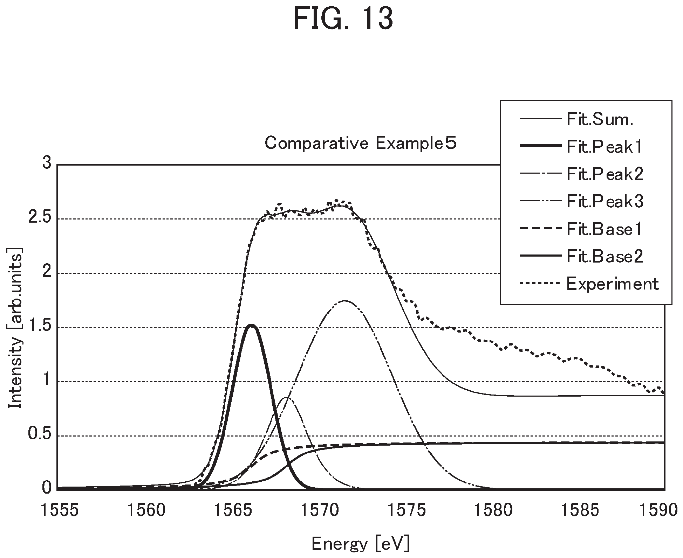

The results of peak separation performed on the XAFS spectrum in Example 1 are shown in FIG. 10. Likewise, FIG. 11 shows the analysis results of separation of peaks in the XAFS in Example 2, FIG. 12 shows the analysis results of separation of peaks in the XAFS in Comparative Example 4 and FIG. 13 shows the analysis results of separation of peaks in the XAFS in Comparative Example 5.

Experiment is an actually measured XAFS spectrum, Fit. Peak1 is an intensity peak separated around 1566 eV, Fit. Peak2 is an intensity peak separated around 1568 eV and Fit. Peak3 is an intensity peak separated around 1572 eV. Here, the results of calculation of XAFS peak top ratio P = (intensity peak top at around 1572 eV) / (intensity peak top at around 1566 eV) are shown in Table 4 for the barrier films in Examples 1 to 13 and Comparative Examples 1 to 10.

[Elemental analysis of covering layer]

For the surfaces of the covering layers in the barrier films in Examples 1 to 13 and Comparative Examples 1 to 10, the narrow spectra of elements were measured using an X-ray photoelectron spectrometer (XPS). Thereafter, under conditions which will be described later, the surfaces after the measurement were etched, and new measurement surfaces were exposed. For the exposed measurement surfaces, the narrow spectra of the elements were measured under the same conditions. For the narrow spectra of Cls and Si2p, a background was subtracted by a Shirley method using analysis software, and thus the integrated intensities (areas) of the peaks of the elements were obtained. The percentage of the elements (element %) were calculated using the obtained integrated intensities (areas). The Si/C ratio was calculated from the proportions of the elements after etching for 60 seconds twice, and is shown in Table 4.

<X-ray photoelectron spectrum measurement conditions>

Device: ESCA3400 made by Shimadzu Corporation. X-ray source: MgK$\alpha$
Emission current: 20 mA
Acceleration voltage: 10 kV
Resolution: low
Measurement region: about 6mm $\varphi$

<Etching conditions>

Ion species: Ar$^+$
Ar gas introduction pressure: $2.0 \times 10^{-2}$ Pa
Emission current: 30 mA
Acceleration voltage: 0.3 kV
Etching time: 60 seconds $\times$ 2 times

[Table 4]

|  | XAFS peak top ratio | Si / C ratio in coating layer XPS |
| --- | --- | --- |
| Example 1 | 0.88 | 1.43 |
| Example 2 | 0.93 | 1.43 |
| Example 3 | 1.00 | 1.43 |
| Example 4 | 0.88 | 1.38 |
| Example 5 | 0.88 | 1.47 |
| Example 6 | 0.88 | 1.52 |
| Example 7 | 0.88 | 1.61 |
| Example 8 | 0.88 | 1.41 |
| Example 9 | 0.88 | 1.59 |
| Example 10 | 0.88 | 1.57 |
| Example 11 | 0.81 | 1.43 |
| Example 12 | 0.81 | 1.61 |
| Example 13 | 0.90 | 1.43 |
| Example 14 | 0.88 | - |
| Example 15 | 0.90 | - |
| Comparative Example 1 | 0.68 | 1.43 |
| Comparative Example 2 | 0.68 | 1.43 |
| Comparative Example 3 | 1.09 | 1.43 |
| Comparative Example 4 | 1.16 | 1.43 |
| Comparative Example 5 | 1.14 | 1.43 |
| Comparative Example 6 | 1.12 | 1. 43 |
| Comparative Example 7 | 0.88 | 1.25 |
| Comparative Example 8 | 0.88 | 1.70 |
| Comparative Example 9 | 0.88 | 1.66 |
| Comparative Example 10 | 1.16 | 1.43 |

<Production of multilayer member>

For the barrier films in Examples 1 to 13 and Comparative Examples 1 to 10, the surface on the side of the covering layer 130 was bonded to a second biaxially stretched polypropylene film 140 (thickness of 20 $\mu$m) via a second adhesive layer 162 by a dry lamination method using a polyurethane two-component curing solvent-based adhesive. Furthermore, the surface of the barrier film on the side opposite to the covering layer 130 was bonded to a sealant layer (unstretched polypropylene film having a thickness of 60 $\mu$m) via a first adhesive layer 161 by the dry lamination method using a two-component curing solvent-based adhesive, and thus the multilayer member in Example 1 was produced.

<Retort treatment>

The multilayer members in Examples 1 to 13 and Comparative Examples 1 to 10 were subjected to the retort treatment at 121°C for 30 minutes and the high retort treatment at 135°C for 30 minutes.

<Measurement of barrier properties of barrier film and multilayer member>

For the barrier films in Examples 1 to 13 and Comparative Examples 1 to 10 and the multilayer members using the barrier films, the values of water vapor permeability and oxygen permeability were measured. The results are shown in Tables 5 and 6.

The oxygen permeability (cc/(m$^2$·day·atm), represented by "OTR" in the table) was measured in accordance with JIS K 7126-2 using an oxygen permeability measurement device (made by MOCON, product name "OX-TRAN 2/20") under measurement conditions of 23°C and 90% RH.

The water vapor permeability (g/(m$^2$·day), represented by "WVTR" in the table) was measured in accordance with B method, JIS K 7129 using a water vapor permeability measurement device (made by MOCON, product name "PERMATORAN-W 3/31") under measurement conditions of 40°C and 100% RH.

<Measurements of composite elastic modulus and indentation hardness of covering layer>

For the multilayer members in Examples 1 to 13 and Comparative Examples 1 to 10, the composite elastic modulus (GPa) and the indentation hardness (GPa) of the covering layer in the multilayer member after the heat sterilization treatment were measured under the following conditions. The results thereof are shown in Tables 5 and 6. Measurement device: TI-950 Tribo Indenter made by HYSITRON

Measurement location: from the cross-sectional side of the covering layer
Measurement mode: indentation
Indenter: cubecorner indenter, TI-0037
Number of data points: 200 points/second
Measurement profile
0 → 10 sec: 0 → 15 μN
10 → 15 sec: 15 μN
15 → 25 sec: 15 → 0 μN

[Table 5]

| | Barrier film alone | | After laminate | | After retort | | After retort | |
| | | | | | | | Hardness | Elastic modulus |
| | OTR | WVTR | OTR | WVTR | OTR | WVTR | (GPa) | (GPa) |
|---|---|---|---|---|---|---|---|---|
| Example 1 | 0.3 | 0.3 | 0.3 | 0.2 | 0.7 | 0.4 | 1.2 | 6.7 |
| Example 2 | 0.5 | 0.2 | 0.4 | 0.2 | 0.6 | 0.4 | 1.2 | 6.7 |
| Example 3 | 0.5 | 0.2 | 0.4 | 0.2 | 0.6 | 0.4 | 1.2 | 6.7 |
| Example 4 | 0.3 | 0.3 | 0.3 | 0.2 | 0.7 | 0.4 | 1.1 | 6.7 |
| Example 5 | 0.3 | 0.3 | 0.3 | 0.2 | 0.4 | 0.4 | 1.4 | 7.1 |
| Example 6 | 0.3 | 0.3 | 0.3 | 0.2 | 0.9 | 0.4 | 1.5 | 7.2 |
| Example 7 | 0.3 | 0.3 | 0.3 | 0.2 | 0.8 | 0.4 | 1.6 | 7.9 |
| Example 8 | 0.3 | 0.3 | 0.3 | 0.2 | 0.8 | 0.4 | 1.6 | 7.2 |
| Example 9 | 0.3 | 0.3 | 0.3 | 0.2 | 0.6 | 0.4 | 1.4 | 7.0 |
| Example 10 | 0.3 | 0.3 | 0.3 | 0.2 | 1.2 | 0.4 | 1.5 | 7.9 |
| Example 11 | 0.3 | 0.3 | 0.3 | 0.2 | 1.8 | 0.4 | 1.4 | 6.9 |
| Example 12 | 0.3 | 0.3 | 0.3 | 0.2 | 0.6 | 0.4 | 1.6 | 7.7 |

(continued)

| | Barrier film alone | | After laminate | | After retort | | After retort | |
|---|---|---|---|---|---|---|---|---|
| | | | | | | | Hardness | Elastic modulus |
| | OTR | WVTR | OTR | WVTR | OTR | WVTR | (GPa) | (GPa) |
| Example 13 | 0.3 | 0.3 | 0.3 | 0.2 | 0.4 | 0.4 | 1.2 | 6.7 |
| Example 14 | 0.3 | 0.5 | 0.6 | 0.5 | 2.1 | 0.7 | - | - |
| Example 15 | 0.3 | 0.4 | 0.5 | 0.4 | 1.5 | 0.6 | - | - |
| Comparative Example 1 | 0.4 | 0.3 | 0.3 | 0.2 | 7.5 | 0.9 | 1.2 | 6.7 |
| Comparative Example 2 | 0.4 | 0.3 | 0.3 | 0.2 | 6.3 | 0.8 | 1.2 | 6.7 |
| Comparative Example 3 | 0.5 | 5.2 | 0.4 | 2.0 | 0.6 | 2.2 | 1.2 | 6.7 |
| Comparative Example 4 | 0.5 | 5.3 | 0.4 | 1.9 | 0.6 | 2.0 | 1.2 | 6.7 |
| Comparative Example 5 | 0.5 | 5.2 | 0.4 | 1.9 | 0.6 | 2.1 | 1.2 | 6.7 |
| Comparative Example 6 | 0.5 | 5.3 | 0.3 | 2.1 | 0.6 | 2.3 | 1.2 | 6.7 |
| Comparative Example 7 | 0.3 | 0.3 | 0.3 | 0.2 | >30.0 | 1.0 | 0.8 | 5.2 |
| Comparative Example 8 | 0.3 | 0.3 | 0.3 | 0.2 | 2.8 | 0.4 | 1.8 | 8.1 |
| Comparative Example 9 | 0.3 | 0.3 | 0.3 | 0.2 | 3.5 | 0.4 | 1.3 | 8.9 |
| Comparative Example 10 | 0.3 | 5.2 | 0.3 | 1.9 | 0.4 | 2.0 | 1.2 | 6.7 |

[Table 6]

| | After high retort | | After high retort | |
|---|---|---|---|---|
| | | | Hardness | Elastic modulus |
| | OTR | WVTR | (GPa) | (GPa) |
| Example 1 | 1.7 | 0.6 | 1.4 | 7.1 |
| Example 2 | 1.5 | 0.8 | 1.4 | 7.1 |
| Example 3 | 1.5 | 0.9 | 1.4 | 7.1 |
| Example 4 | 1.9 | 0.6 | 1.1 | 6.4 |
| Example 5 | 2.4 | 0.6 | 1.2 | 7.5 |
| Example 6 | 13.1 | 0.6 | 1.4 | 8.5 |
| Example 7 | 17.6 | 0.6 | 1.4 | 8.7 |
| Example 8 | 2.3 | 0.6 | 1.5 | 7.4 |
| Example 9 | 3.8 | 0.6 | 1.4 | 7.3 |
| Example 10 | 4.5 | 0.6 | 1.5 | 8.4 |
| Example 11 | 2.0 | 0.6 | 1.4 | 7.0 |
| Example 12 | 3.5 | 0.6 | 1.5 | 8.3 |
| Example 13 | 1.2 | 0.6 | 1.4 | 7.1 |
| Example 14 | - | - | - | - |
| Example 15 | - | - | - | - |
| Comparative Example 1 | 8.2 | 1.2 | 1.4 | 7.1 |
| Comparative Example 2 | 7.4 | 1.1 | 1.4 | 7.1 |
| Comparative Example 3 | 1.5 | 2.2 | 1.4 | 7.1 |
| Comparative Example 4 | 1.5 | 2.2 | 1.4 | 7.1 |

(continued)

| | After high retort | | After high retort | |
| --- | --- | --- | --- | --- |
| | | | Hardness | Elastic modulus |
| | OTR | WVTR | (GPa) | (GPa) |
| Comparative Example 5 | 1.5 | 2.1 | 1.4 | 7.1 |
| Comparative Example 6 | 1.5 | 2.3 | 1.4 | 7.1 |
| Comparative Example 7 | >30.0 | 1.3 | 0.8 | 5.3 |
| Comparative Example 8 | >30.0 | 1.2 | 1.8 | 8.9 |
| Comparative Example 9 | >30.0 | 1.2 | 1.4 | 8.9 |
| Comparative Example 10 | 1.2 | 2.1 | 1.4 | 7.1 |

It can be understood from Tables 5 and 6 that the multilayer members of the barrier films using the polypropylene base materials according to the present embodiment in which the peak top ratio P obtained from the XAFS spectrum is equal to or greater than 0.70 and less than 1.05 have high barrier properties after the retort treatment.

It can be understood that the multilayer members using the polypropylene base materials in which the composite elastic modulus is equal to or greater than 5.0 GPa and equal to or less than 8.5 GPa, and the indentation hardness is equal to or greater than 0.9 GPa and equal to or less than 1.7 GPa have excellent oxygen barrier properties after the retort treatment.

EXPLANATION OF REFERENCE NUMERALS

110 (first) polypropylene base material
115 underlayer
120 vapor-deposited film
130 covering layer
140 second polypropylene base material
150 sealant layer
161 first adhesive layer
162 second adhesive layer
100, 200 multilayer member
100A barrier film
10 film formation device
P plasma
X rotation axis
11A base material conveyance mechanism
11B plasma pretreatment mechanism
11C film formation mechanism
12 decompression chamber
12A base material conveyance chamber
12B plasma pretreatment chamber
12C film formation chamber
13 unwinding roller
14a to 14d guide roll
15 winding roller
20 pretreatment roller
21 electrode unit
23 magnetic field formation unit
23a first surface
23b second surface
231 first magnet
231c first axial part
232 second magnet

232c second axial part
232d connection part
24 evaporation mechanism
24b boat
25 film formation roller
31 power supply wire
32 power supply
35a to 35c partition wall
50 plasma supply mechanism
51 hollow cathode
61 vapor deposition material supply unit
63 aluminum vapor

**Claims**

1. A barrier film comprising a polypropylene base material, an underlayer and an aluminum oxide vapor-deposited film that are stacked in this order,

   wherein when an X-ray absorption fine structure analysis is performed from a side of a surface of the barrier film opposite to a side of the polypropylene base material, in the aluminum oxide vapor-deposited film, a peak top ratio P defined by an equation below is equal to or greater than 0.70 and less than 1.05
   where P = (intensity peak top at around 1572 eV) / (intensity peak top at around 1566 eV).

2. The barrier film according to claim 1, wherein a covering layer having barrier properties is stacked on the aluminum oxide vapor-deposited film.

3. The barrier film according to claim 2, wherein in the covering layer, a ratio of silicon atoms to carbon atoms (Si/C) measured by X-ray photoelectron spectroscopy (XPS) is equal to or greater than 1.30 and equal to or less than 1.65.

4. The barrier film according to claim 1, wherein the underlayer is an anchor coat layer formed on the polypropylene base material.

5. The barrier film according to claim 1, wherein the underlayer is a surface resin layer formed on the polypropylene base material, the surface resin layer including a polyamide resin.

6. The barrier film according to claim 4, wherein the polypropylene base material includes at least a first layer and a second layer as both surface layers, the first layer is formed on a side of the underlayer,

   the first layer contains a copolymer of propylene and another monomer,
   the underlayer is the anchor coat layer and
   the first layer of the polypropylene base material, the anchor coat layer, the aluminum oxide vapor-deposited film and a covering layer having barrier properties are stacked in this order.

7. The barrier film according to claim 5, wherein the polypropylene base material includes at least a first layer and a second layer as both surface layers, the first layer is formed on a side of the underlayer,

   the first layer contains a modified polypropylene,
   the underlayer is the surface resin layer including the polyamide resin and
   the first layer of the polypropylene base material, the surface resin layer including the polyamide resin, the aluminum oxide vapor-deposited film and a covering layer having barrier properties are stacked in this order.

8. The barrier film according to claim 1, wherein the polypropylene base material includes at least a first layer and a second layer as both surface layers, the second layer is formed on a surface on a side opposite to a side of the underlayer,

   the second layer contains a copolymer of propylene and another monomer and
   the first layer of the polypropylene base material, the underlayer, the aluminum oxide vapor-deposited film and a covering layer having barrier properties are stacked in this order.

9. A multilayer member that is used for a packaging bag containing retort pouch food or boiled food and has been subjected to heat sterilization treatment, the multilayer member comprising the barrier film according to any one of claims 1 to 8 and a sealant layer,
   wherein in a covering layer of the multilayer member, a composite elastic modulus measured from a cross section of the covering layer by a nanoindentation method is equal to or greater than 5.0 GPa and equal to or less than 8.5 GPa, and an indentation hardness measured from the cross section of the covering layer by the nanoindentation method is equal to or greater than 0.9 GPa and equal to or less than 1.7 GPa.

10. A packaging product comprising the multilayer member according to claim 9.

# FIG. 1

100A

130
120
115
110

# FIG. 2

EP 4 786 163 A1

# FIG. 3

# FIG. 4

# FIG. 5

# FIG. 6

# FIG. 7

100

140
162
130
120
115
100A
110
161
150

# FIG. 8

# FIG. 9

Example 1

# FIG. 10

# FIG. 11

# FIG. 12

# FIG. 13

**EP 4 786 163 A1**

## INTERNATIONAL SEARCH REPORT

International application No.

**PCT/JP2024/034877**

| A. | CLASSIFICATION OF SUBJECT MATTER |
|---|---|

*B32B 9/00*(2006.01)i; *B32B 27/00*(2006.01)i; *B32B 27/32*(2006.01)i; *B65D 65/40*(2006.01)i; *C23C 14/08*(2006.01)i
FI:  B32B9/00 A; B32B27/00 H; B32B27/32 D; B65D65/40 D; C23C14/08 A

According to International Patent Classification (IPC) or to both national classification and IPC

| B. | FIELDS SEARCHED |
|---|---|

Minimum documentation searched (classification system followed by classification symbols)

B32B1/00-43/00; B65D65/00-65/46; C23C14/00-14/58

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2020-29095 A (DAI NIPPON PRINTING CO., LTD.) 27 February 2020 (2020-02-27) entire text | 1-10 |
| A | JP 2023-127642 A (TORAY ADVANCED FILM CO., LTD.) 14 September 2023 (2023-09-14) entire text | 1-10 |
| A | JP 2014-213530 A (TOPPAN PRINTING CO., LTD.) 17 November 2014 (2014-11-17) entire text | 1-10 |
| A | JP 2023-131024 A (DAI NIPPON PRINTING CO., LTD.) 21 September 2023 (2023-09-21) entire text | 1-10 |
| A | JP 2020-44708 A (DAI NIPPON PRINTING CO., LTD.) 26 March 2020 (2020-03-26) entire text | 1-10 |
| A | JP 11-170427 A (DAI NIPPON PRINTING CO., LTD.) 29 June 1999 (1999-06-29) entire text | 1-10 |

☑ Further documents are listed in the continuation of Box C.  ☑ See patent family annex.

| \* | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 November 2024 | 19 November 2024 |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
| --- |
| **PCT/JP2024/034877** |

**C.** **DOCUMENTS CONSIDERED TO BE RELEVANT**

| Category* | Citation of document, with indication, where appropriate, of the relevant passages | Relevant to claim No. |
| --- | --- | --- |
| A | JP 9-323373 A (TORAY INDUSTRIES, INC.) 16 December 1997 (1997-12-16)<br>entire text | 1-10 |

Form PCT/ISA/210 (second sheet) (July 2022)

# EP 4 786 163 A1

INTERNATIONAL SEARCH REPORT
**Information on patent family members**

| International application No. |
| --- |
| **PCT/JP2024/034877** |

| Patent document cited in search report | | | Publication date (day/month/year) | Patent family member(s) | Publication date (day/month/year) |
| --- | --- | --- | --- | --- | --- |
| JP | 2020-29095 | A | 27 February 2020 | (Family: none) | |
| JP | 2023-127642 | A | 14 September 2023 | (Family: none) | |
| JP | 2014-213530 | A | 17 November 2014 | (Family: none) | |
| JP | 2023-131024 | A | 21 September 2023 | (Family: none) | |
| JP | 2020-44708 | A | 26 March 2020 | (Family: none) | |
| JP | 11-170427 | A | 29 June 1999 | (Family: none) | |
| JP | 9-323373 | A | 16 December 1997 | (Family: none) | |

Form PCT/ISA/210 (patent family annex) (July 2022)

**EP 4 786 163 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017177343 A
- JP H11170427 A

- WO 2022085586 A